# EUROPEAN PATENT SPECIFICATION

(11) **EP 1 771 772 B1**
(45) Date of publication and mention of the grant of the patent: **04.02.2009**
(21) Application number: 05760106.4
(22) Date of filing: 06.07.2005
(51) Int. Cl.: G03F 7/18

(54) **METHOD OF MANUFACTURING PHOTOSENSITIVE LAMINATED BODY AND APPARATUS THEREFOR**
VERFAHREN ZUR HERSTELLUNG EINES LICHTEMPFINDLICHEN LAMINIERTEN KÖRPERS UND VORRICHTUNG DAFÜR
APPAREIL ET PROCEDE POUR LA FABRICATION D'UN CORPS STRATIFIE PHOTODENSIBLE

(30) Priority: 06.07.2004 JP 2004199886; 25.08.2004 JP 2004245816
(43) Date of publication of application: 11.04.2007
(73) Proprietor: FUJIFILM Corporation, Minato-ku Tokyo (JP)
(72) Inventor: SUEHARA, Kazuyoshi, Fujinomiya-shi, Shizuoka 4188666 (JP); AKIYOSHI, Nobuyasu, Fujinomiya-shi, Shizuoka 4188666 (JP); IMOTO, Kenichi, Fujinomiya-shi, Shizuoka 4188666 (JP); MORI, Ryo, Fujinomiya-shi, Shizuoka 4188666 (JP); SUZUKI, Chiaki, Minami-ashigara-shi, Kanagawa 250-0193 (JP); SUGIHARA, Ryoichi, Fujinomiya-shi, Shizuoka 4188666 (JP)
(74) Representative: Grünecker, Kinkeldey, Stockmair & Schwanhäusser Anwaltssozietät
(86) International application number: PCT/JP2005/012879
(87) International publication number: WO 2006/004225

(56) References cited:
- EP-A- 0 267 807
- EP-A- 0 686 477
- EP-A- 0 979 729
- EP-A- 1 072 390
- WO-A-20/05119631
- PATENT ABSTRACTS OF JAPAN vol. 1996, no. 11, 29 November 1996 (1996-11-29) & JP 08 179512 A (FUJI PHOTO FILM CO LTD), 12 July 1996 (1996-07-12)
- PATENT ABSTRACTS OF JAPAN vol. 1999, no. 05, 31 May 1999 (1999-05-31) & JP 11 034280 A (SOMAR CORP), 9 February 1999 (1999-02-09) cited in the application

## Description

### Technical Field

The present invention relates to an apparatus for and a method of manufacturing a photosensitive laminated body by delivering two or more elongate photosensitive webs each comprising a photosensitive material layer and a protective film that are successively deposited on a support, peeling off the protective films to expose the photosensitive material layers, and joining the exposed photosensitive material layers parallel to each other to substrates.

### Background Art

Substrates for liquid crystal panels, substrates for printed wiring boards, and substrates for PDP panels, for example, have a photosensitive sheet (photosensitive web) having a photosensitive material (photosensitive resin) layer and applied to a substrate surface. The photosensitive sheet comprises a photosensitive material layer and a protective film that are successively deposited on a flexible plastic support.

An applying apparatus for applying such a photosensitive sheet usually operates to feed substrates such as glass substrates, resin substrates, or the like at predetermined intervals, and peel off the protective film from the photosensitive sheet for a length corresponding to the range of the photosensitive material layer that is to be applied to each of the substrates.

According to a method of and an apparatus for applying a film as disclosed in Japanese Laid-Open Patent Publication No. 11-34280, for example, as shown in FIG. 32 of the accompanying drawings, a laminated film 1a unreeled from a film roll 1 is trained around guide rolls 2a, 2b and extends along a horizontal film feed plane. The guide roll 2b is combined with a rotary encoder 3 for outputting as many pulses as depending on the length by which the laminated film 1a is fed.

The laminated film 1a that extends along the horizontal film feed plane from the guide rollers 2a, 2b is trained around a suction roll 4. A partial cutter 5 and a cover film peeler 6 are disposed along the horizontal film feed plane between the guide roll 2b and the suction roll 4.

The partial cutter 5 has a pair of disk cutters 5a, 5b. The disk cutters 5a, 5b are movable transversely across the laminated film 1a to cut off a cover film (not shown) of the laminated film 1a together with a photosensitive resin layer (not shown) on the reverse side of the cover film.

The cover film peeler 6 presses a sticky tape 7a unreeled from a sticky tape roll 7 strongly against the cover film between presser rollers 8a, 8b, and then winds up the sticky tape 7a around a takeup roll 9. The cover film is peeled off from the photosensitive resin layer by the sticky tape 7a, and wound together with the sticky tape 7a around the takeup roll 9.

The suction roll 4 is followed downstream by a pair of lamination rolls 12a, 12b for superposing and pressing the laminated film 1a against upper surfaces of a plurality of substrates 11 which are successively intermittently fed by a substrate feeder 10. A support film takeup roll 13 is disposed downstream of the lamination rolls 12a, 12b. Light-transmissive support films (not shown) applied to the respective substrates 11 are peeled off and wound up by the support film takeup roll 13.

As liquid crystal panels, plasma display panels, and other panels are becoming larger in size, the sizes of substrate for use in those panels are also becoming larger in size. Larger-size substrates have transversely larger, i.e., wider, areas to which a photosensitive resin layer is to be transferred, and hence a photosensitive sheet for use therewith needs to have a larger transverse dimension, i.e., a larger width.

However, a wider photosensitive sheet in the form of a roll cannot be handled efficiently with ease, and a reel-out mechanism for unreeling the photosensitive sheet from the roll is also larger in size. The wider photosensitive sheet is heavier, is more liable to develop wrinkles therein, and is more difficult to handle.

### Disclosure of Invention

It is a major object of the present invention to provide an apparatus for and a method of manufacturing a photosensitive laminated body, which is easy to handle, by reliably joining two or more elongate photosensitive webs parallel to each other to substrates through a simple process and arrangement.

According to the present invention, there is provided an apparatus for manufacturing a photosensitive laminated body, comprising at least two web reel-out mechanisms for synchronously reeling out elongate photosensitive webs each comprising a support, a photosensitive material layer disposed on the support, and a protective film disposed on the photosensitive material layer, the protective film having a peel-off section and a residual section, at least two processing mechanisms for forming processed regions which are transversely severable in the protective films of the elongate photosensitive webs which have been reeled out by the web reel-out mechanisms, at respective boundary positions between the peel-off section and the residual section, at least two peeling mechanisms for peeling the peel-off section off from each of the elongate photosensitive webs, leaving the residual section, a substrate feed mechanism for feeding a substrate which has been heated to a predetermined temperature to a joining position, a joining mechanism for positioning the residual section between substrates and joining at least two exposed areas of the photosensitive material layers from which the peel-off section is peeled off, integrally parallel to each other to the substrate in the joining position, at least two detecting mechanisms disposed closely to the joining position, for directly detecting the boundary positions of the elongate photosensitive webs or detecting marks disposed on the elongate photosensitive webs in association with the boundary positions, and a control mechanism for adjusting relative positions of the boundary positions and the substrate in the joining position and relative positions of the boundary positions themselves, based on boundary position information detected by the detecting mechanisms.

The detecting mechanisms should preferably be disposed upstream of and closely to the joining position because the relative positions of the elongate photosensitive webs and the substrate can be adjusted under simple control.

Reservoir mechanisms should preferably be disposed between the processing mechanisms and the peeling mechanisms, for changing speeds or states at which the elongate photosensitive webs are fed. Therefore, the elongate photosensitive webs are fed intermittently through the processing mechanisms, respectively, and thereafter fed continuously through the reservoir mechanisms in the peeling mechanisms and subsequently thereto.

Furthermore, at least two tension control mechanisms should preferably be disposed between the peeling mechanisms and the joining mechanism, for applying tension to the elongate photosensitive webs. Consequently, each of the elongate photosensitive webs can be adjusted for stretching, allowing the boundary positions to be adjusted easily into alignment with the joining position.

Furthermore, a cutting mechanism should preferably be disposed downstream of the joining mechanism, for cutting off the elongate photosensitive webs together between the substrates.

At least two support peeling mechanisms should preferably be disposed downstream of the joining mechanism, for peeling the supports off from each of joined substrates. Each of the supports may automatically be peeled off after being cut to lengths corresponding to respective substrates, or may continuously be wound so as to be peeled off automatically.

The joining mechanism should preferably comprise a pair of rubber rollers which can be heated to a predetermined temperature, and a roller clamp unit for moving one of the rubber rollers back and forth. The roller clamp unit should preferably comprise a cylinder for applying a clamping pressure to the one of the rubber rollers, and a cam movable by an actuator for moving the cylinder back and forth.

A preheating unit should preferably be disposed upstream of and closely to the joining mechanism, for preheating the elongate photosensitive webs to a predetermined temperature.

According to the present invention, there is also provided a method of manufacturing a photosensitive laminated body, comprising the steps of synchronously reeling out elongate photosensitive webs each comprising a support, a photosensitive material layer disposed on the support, and a protective film disposed on the photosensitive material layer, the protective film having a peel-off section and a residual section, forming processed regions which are transversely severable in the protective films of the elongate photosensitive webs which have been reeled out, at respective boundary positions between the peel-off section and the residual section, peeling the peel-off section off from each of the elongate photosensitive webs, leaving the residual section, obtaining boundary position information by directly detecting the boundary positions of the elongate photosensitive webs or detecting marks disposed on the elongate photosensitive webs in association with the boundary positions, feeding a substrate which has been heated to a predetermined temperature to a joining position, adjusting relative positions of the boundary positions and the substrate in the joining position and relative positions of the boundary positions themselves, based on the obtained boundary position information, and positioning the residual section between substrates and joining at least two exposed areas of the photosensitive material layers from which the peel-off section is peeled off, integrally parallel to each other to the substrate in the joining position.

According to the present invention, since the boundary positions of the elongate photosensitive webs or marks disposed on the elongate photosensitive webs in association with the boundary positions are directly detected, the boundary positions can highly accurately be positioned with respect to the joining position. As the relative positions of the boundary positions and the substrate in the joining position and relative positions of the boundary positions themselves are adjusted based on the obtained boundary position information, the photosensitive material layers of the elongate photosensitive webs can be joined accurately parallel to each other to a desired area of the substrate through a simple process and arrangement.

Therefore, at least two photosensitive material layers that are transversely spaced from each other can well be transferred onto a wide substrate, and a high-quality photosensitive laminated body can efficiently be produced. Inasmuch as the elongate photosensitive webs do not need to be wide and can easily be handled, the manufacturing method can be performed efficiently, and the expenses of the manufacturing facility can be reduced.

The above and other objects, features, and advantages of the present invention will become more apparent from the following description when taken in conjunction with the accompanying drawings in which preferred embodiments of the present invention are shown by way of illustrative example.

### Brief Description of Drawings

FIG. 1 is a schematic side elevational view of a manufacturing apparatus according to a first embodiment of the present invention;
FIG. 2 is an enlarged fragmentary cross-sectional view of an elongate photosensitive web used in the manufacturing apparatus;
FIG. 3 is a fragmentary plan view of the elongate photosensitive web with adhesive labels applied thereto;
FIG. 4 is a front elevational view of a joining mechanism of the manufacturing apparatus;
FIG. 5 is a perspective view of a film feed roller and a nip roller group;
FIG. 6 is a fragmentary cross-sectional view of a through region of the manufacturing apparatus;
FIG. 7 is a schematic view of a portion of the manufacturing apparatus, showing an initial state thereof;
FIG. 8 is a fragmentary side elevational view showing the manner in which a protective film is peeled off from the elongate photosensitive web;
FIG. 9 is a schematic view of a portion of the manufacturing apparatus, showing the manner in which a glass substrate enters between rubber rollers;
FIG. 10 is a schematic view of a portion of the manufacturing apparatus, showing the manner in which the rubber rollers start to rotate;
FIG. 11 is a schematic view of a portion of the manufacturing apparatus, showing its operation upon completion of a lamination process on a first glass substrate;
FIG. 12 is a schematic view of a portion of the manufacturing apparatus, showing the manner in which the rubber rollers and substrate feed rollers rotate;
FIG. 13 is a fragmentary cross-sectional view of glass substrates to which a photosensitive resin layer is transferred;
FIG. 14 is a schematic view of a portion of the manufacturing apparatus, showing the manner in which the substrate feed rollers are spaced from an end of a joined substrate;
FIG. 15 is a schematic view of a portion of the manufacturing apparatus, showing the manner in which elongate photosensitive webs are severed between joined substrates;
FIG. 16 is a schematic view of a portion of the manufacturing apparatus, showing a stopped state thereof;
FIG. 17 is a schematic view of a portion of the manufacturing apparatus, showing a finished state thereof;
FIG. 18 is a schematic view of a portion of the manufacturing apparatus, showing the manner in which the elongate photosensitive webs have their leading ends set in position;
FIG. 19 is a plan view showing the manner in which photosensitive resin layers are advanced with respect to a glass substrate;
FIG. 20 is a plan view showing the manner in which photosensitive resin layers are stretched with respect to a glass substrate;
FIG. 21 is a plan view showing the manner in which photosensitive resin layers have their leading ends in different positions with respect to a glass substrate;
FIG. 22 is a plan view showing the manner in which photosensitive resin layers have different lengths with respect to a glass substrate;
FIG. 23 is a plan view showing the manner in which photosensitive resin layers have different lengths and have their leading ends in different positions with respect to a glass substrate;
FIG. 24 is a schematic side elevational view of a manufacturing apparatus according to a second embodiment of the present invention;
FIG. 25 is a plan view showing the manner in which photosensitive resin layers having a prescribed length are applied to a glass substrate;
FIG. 26 is a plan view showing the manner in which photosensitive resin layers longer than a prescribed length are applied to a glass substrate;
FIG. 27 is a plan view showing the manner in which photosensitive resin layers shorter than a prescribed length are applied to a glass substrate;
FIG. 28 is a schematic side elevational view of a manufacturing apparatus according to a third embodiment of the present invention;
FIG. 29 is an enlarged cross-sectional view of a pre-peeler of the manufacturing apparatus according to the third embodiment;
FIG. 30 is an enlarged cross-sectional view showing the manner in which the pre-peeler operates;
FIG. 31 is a view illustrative of the manner in which the position of a photosensitive resin layer applied to a glass substrate is detected; and

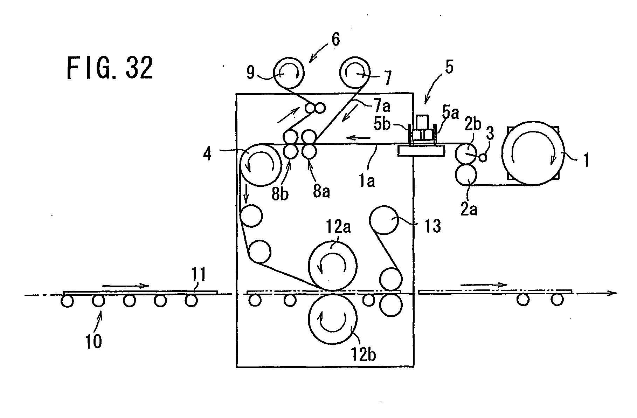

FIG. 32 is a schematic side elevational view of a conventional film applying apparatus.

### Best Mode for Carrying Out the Invention

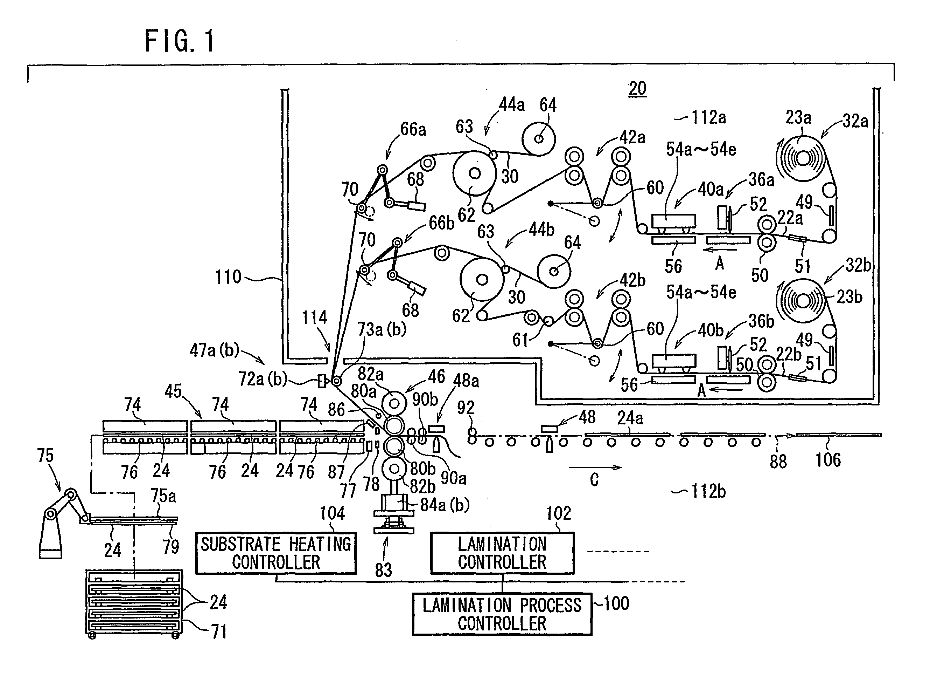

FIG. 1 shows in schematic side elevation an apparatus 20 for manufacturing a photosensitive laminated body according to a first embodiment of the present invention. The manufacturing apparatus 20 operates to thermally transfer respective photosensitive resin layers 28 (described later) of elongate photosensitive webs 22a, 22b parallel to each other to glass substrates 24 in a process of manufacturing liquid crystal or organic EL color filters. The photosensitive webs 22a, 22b have such respective widths that the elongate photosensitive web 22a is wider than the photosensitive web 22b, for example.

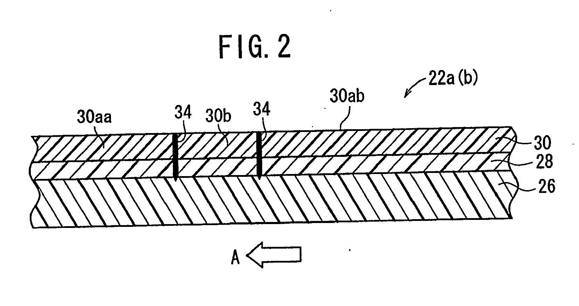

FIG. 2 shows in cross section each of the photosensitive webs 22a, 22b that are employed in the manufacturing apparatus 20. Each of the photosensitive webs 22a, 22b comprises a laminated assembly of a flexible base film (support) 26, a photosensitive resin layer (photosensitive material layer) 28 disposed on the flexible base film 26, and a protective film 30 disposed on the photosensitive resin layer 28.

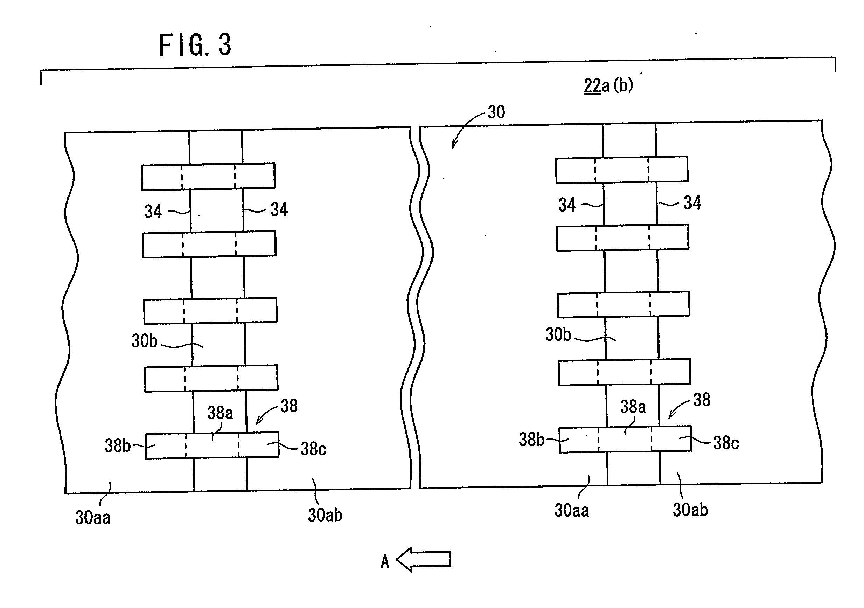

As shown in FIG. 1, the manufacturing apparatus 20 has first and second reel-out mechanisms 32a, 32b for accommodating two (or more) photosensitive web rolls 23a, 23b in the form of rolled photosensitive webs 22a, 22b and synchronously reeling out the photosensitive webs 22a, 22b from the photosensitive web rolls 23a, 23b, first and second processing mechanisms 36a, 36b for forming partly cut regions (processed regions) 34 which are located at transversely severable boundary positions in protective films 30 of the photosensitive webs 22a, 22b reeled out from the photosensitive web rolls 23a, 23b, and first and second label bonding mechanisms 40a, 40b for bonding adhesive labels 38 (see FIG. 3) each having a non-adhesion area 38a to the protective films 30.

The manufacturing apparatus 20 also has, positioned downstream of the first and second label bonding mechanisms 40a, 40b, first and second reservoir mechanisms 42a, 42b for changing the feed mode of the photosensitive webs 22a, 22b from an intermittent feed mode to a continuous feed mode, first and second peeling mechanisms 44a, 44b for peeling predetermined lengths of the protective films 30 from the photosensitive webs 22a, 22b, a substrate feed mechanism 45 for feeding a glass substrate 24 which is heated to a predetermined temperature to a joining position, and a joining mechanism 46 for joining the photosensitive resin layers 28 which have been exposed by peeling off the protective films 30, integrally and parallel to each other, to the glass substrate 24.

First and second detecting mechanisms 47a, 47b for directly detecting the partly cut regions 34 at the boundary positions of the photosensitive webs 22a, 22b are disposed upstream of and closely to the joining position in the joining mechanism 46. An inter-substrate web cutting mechanism 48 for cutting the photosensitive webs 22a, 22b altogether between adjacent glass substrates 24 is disposed downstream of the joining mechanism 46. A web cutting mechanism 48a that is used when the manufacturing apparatus 20 starts and finishes operating is disposed upstream of the inter-substrate web cutting mechanism 48.

Joining bases 49 for joining the trailing ends of photosensitive webs 22a, 22b that have essentially been used up and the leading ends of photosensitive webs 22a, 22b that are to be newly used are disposed downstream or and closely to the first and second reel-out mechanisms 32a, 32b, respectively. The joining bases 49 are followed downstream by respective film end position detectors 51 for controlling transverse shifts of the photosensitive webs 22a, 22b due to winding irregularities of the photosensitive web rolls 23a, 23b. The film ends of the photosensitive webs 22a, 22b are positionally adjusted by transversely moving the first and second reel-out mechanisms 32a, 32b. However, the film ends of the photosensitive webs 22a, 22b may be adjusted by position adjusting mechanisms combined with rollers. Each of the first and second reel-out mechanisms 32a, 32b may comprise a multi-shaft mechanism including two or three unreeling shafts for supporting one of the photosensitive web rolls 23a, 23b and feeding out one of the photosensitive webs 22a, 22b.

The first and second processing mechanisms 36a, 36b are disposed downstream of respective roller pairs 50 for calculating the diameters of the photosensitive web rolls 23a, 23b accommodated in the respective first and second reel-out mechanisms 32a, 32b. The first and second processing mechanisms 36a, 36b have respective single circular blades 52 which travel transversely across the photosensitive webs 22a, 22b to form partly cut regions 34 in the photosensitive webs 22a, 22b at a given position thereon.

As shown in FIG. 2, partly cut regions 34 need to be formed in and across at least the protective films 30. Actually, the circular blades 52 are set to a cutting depth large enough to cut into the photosensitive resin layer 28 or the base film 26 in order to reliably cut off the protective films 30. The circular blades 52 may be fixed against rotation and moved transversely across the photosensitive webs 22a, 22b to form partly cut regions 34, or may be rotated without slippage on the photosensitive webs 22a, 22b and moved transversely across the photosensitive webs 22a, 22b to form partly cut regions 34. The circular blades 52 may be replaced with a laser beam or ultrasonic cutter, a knife blade, or a pushing blade (Thompson blade), for example.

Each of the first and second processing mechanisms 36a, 36b may comprise two processing mechanisms disposed at a predetermined interval in the direction indicated by the arrow A in which the photosensitive webs 22a, 22b are fed, for simultaneously forming two partly cut regions 34 with a residual section 30b interposed therebetween.

Two closely spaced partly cut regions 34 formed in the protective film 30 serve to set a spaced interval between two adjacent glass substrates 24. For example, these partly cut regions 34 are formed in the protective film 30 at positions that are 10 mm spaced inwardly from respective edges of the glass substrates 24. The section of the protective film 30 which is interposed between the partly cut regions 34 and exposed between the glass substrates 24 functions as a mask when the photosensitive resin layer 28 is applied as a frame to the glass substrate 24 in the joining mechanism 46 to be described later.

The first and second label bonding mechanisms 40a, 40b supply adhesive labels 38 for interconnecting a front peel-off section 30aa and a rear peel-off section 30ab in order to leave a residual section 30b of the protective film 30 between glass substrates 24. As shown in FIG. 2, the front peel-off section 30aa which is to be peeled off initially and the rear peel-off section 30ab which is to be peeled off subsequently are positioned on respective both sides of the residual section 30b.

As shown in FIG. 3, each of the adhesive labels 38 is of a rectangular strip shape and is made of the same material as the protective film 30. Each of the adhesive labels 38 has a non-adhesion (or slightly adhesive) area 38a positioned centrally which is free of an adhesive, and a first adhesion area 38b and a second adhesion area 38c which are disposed respectively on the longitudinally opposite ends of the reverse side (adhesion side) of the non-adhesion area 38a, i.e., on the longitudinally opposite end portions of the adhesive label 38, the first adhesion area 38b and the second adhesion area 38c being bonded respectively to the front peel-off section 30aa and the rear peel-off section 30ab.

As shown in FIG. 1, each of the first and second label bonding mechanisms 40a, 40b has suction pads 54a through 54e for applying a maximum of five adhesive labels 38 at predetermined intervals. Support bases 56 that are vertically movable for holding the photosensitive webs 22a, 22b, respectively, from below are disposed in respective positions where adhesive labels 38 are applied to the photosensitive webs 22a, 22b by the suction pads 54a through 54e.

The first and second reservoir mechanisms 42a, 42b have respective dancer rollers 60 which are rotatable and swingable for absorbing a speed difference between the intermittent feed mode in which the photosensitive webs 22a, 22b are fed upstream of the first and second reservoir mechanisms 42a, 42b and the continuous feed mode in which the photosensitive webs 22a, 22b are fed downstream of the first and second reservoir mechanisms 42a, 42b. The second reservoir mechanism 42b also has a dancer roller 61 for equalizing feed path lengths for the photosensitive webs 22a, 22b to travel from the first and second reel-out mechanisms 32a, 32b to the joining mechanism 46.

The first and second peeling mechanisms 44a; 44b, which are disposed downstream of the respective first and second reservoir mechanisms 42a, 42b, have respective suction drums 62 for blocking variations of the tension to which the supplied photosensitive webs 22a, 22b are subjected for thereby stabilizing the tension of the photosensitive webs 22a, 22b when they are subsequently laminated. The first and second peeling mechanisms 44a, 44b also have respective peeling rollers 63 disposed closely to the suction drums 62. The protective films 30 that are peeled off from the photosensitive webs 22a, 22b at a sharp peel-off angle are wound, except residual sections 30b, by respective protective film takeup units 64.

First and second tension control mechanisms 66a, 66b for imparting tension to the photosensitive webs 22a, 22b are disposed downstream of the first and second peeling mechanisms 44a, 44b, respectively. The first and second tension control mechanisms 66a, 66b have respective cylinders 68 that are actuatable to angularly displace respective tension dancers 70 to adjust the tension of the photosensitive webs 22a, 22b with which the tension dancers 70 are held in rolling contact. The first and second tension control mechanisms 66a, 66b may be employed only when necessary, and may be dispensed with.

The first and second detecting mechanisms 47a, 47b have respective photoelectric sensors 72a, 72b such as laser sensors, photosensors, or the like for directly detecting changes in the photosensitive webs 22a, 22b due to wedge-shaped grooves in the partly cut regions 34, steps produced by different thicknesses of the protective films 30, or a combination thereof. Detected signals from the photoelectric sensors 72a, 72b are used as boundary position signals representative of the boundary positions in the protective films 30. The photoelectric sensors 72a, 72b are disposed in confronting relation to respective backup rollers 73a, 73b. Alternatively, non-contact displacement gauges or image inspecting means such as CCD cameras or the like may be employed instead of the photoelectric sensors 72a, 72b.

The positional data of the partly cut regions 34 which are detected by the first and second detecting mechanisms 47a, 47b can be statistically processed and converted into graphic data in real time. When the positional data detected by the first and second detecting mechanisms 47a, 47b show an undue variation or bias, the manufacturing apparatus 20 may generate a warning.

The manufacturing apparatus 20 may employ a different system for generating boundary position signals. According to such a different system, the partly cut regions 34 are not directly detected, but marks are applied to the photosensitive webs 22a, 22b. For example, holes or recesses may be formed in the photosensitive webs 22a, 22b near the partly cut regions 34 in the vicinity of the first and second processing mechanisms 36a, 36b, or the photosensitive webs 22a, 22b may be slit by a laser beam or an aqua jet or may be marked by an ink jet or a printer. The marks on the photosensitive webs 22a, 22b are detected, and detected signals are used as boundary position signals.

The substrate feed mechanism 45 has a plurality of substrate heating units (e.g., heaters) 74 disposed for sandwiching and heating glass substrates 24, and a feeder 76 for feeding glass substrates 24 in the direction indicated by the arrow C. The temperatures of the glass substrates 24 in the substrate heating units 74 are monitored at all times. When the monitored temperature of a glass substrate 24 becomes abnormal, the feeder 76 is inactivated and a warning is issued, and abnormality information is sent to reject and discharge the abnormal glass substrate 24 in a subsequent process, and is also used for quality control and production management. The feeder 76 has an air-floated plate (not shown) for floating and feeding glass substrates 24 in the direction indicated by the arrow C. Instead, the feeder 76 may comprise a roller conveyor for feeding glass substrates 24.

The temperatures of the glass substrates 24 should preferably be measured in the substrate heating units 74 or immediately prior to the joining position according to a contact process (using a thermocouple, for example) or a non-contact process.

A substrate storage frame 71 for storing a plurality of glass substrates 24 is disposed upstream of the substrate heating unit 74. The glass substrates 24 stored in the substrate storage frame 71 are attracted one by one by a suction pad 79 on a hand 75a of a robot 75, taken out from the substrate storage frame 71, and inserted into the substrate heating units 74.

Downstream of the substrate heating units 74, there are disposed a stopper 77 for abutting against the leading end of a glass substrate 24 and holding the glass substrate 24, and a position sensor 78 for detecting the position of the leading end of the glass substrate 24. The position sensor 78 detects the position of the leading end of the glass substrate 24 on its way toward the joining position. After the position sensor 78 has detected the position of the leading end of the glass substrate 24, the glass substrate 24 is fed a predetermined distance and is positioned between rubber rollers 80a, 80b of the joining mechanism 46. Preferably, a plurality of position sensors 78 are disposed at predetermined intervals along the feed path for monitoring the times at which a glass substrate 24 reaches the respective positions of the position sensors 78, thereby to check a delay due to a slippage or the like of the glass substrate 24 when the glass substrate 24 starts to be fed. In FIG. 1, glass substrates 24 are heated by the substrate heating units while the glass substrates 24 are being fed. However, glass substrates 24 may be heated in a batch-heating oven and fed by a robot.

The joining mechanism 46 has a pair of vertically spaced laminating rubber rollers 80a, 80b that can be heated to a predetermined temperature. The joining mechanism 46 also has a pair of backup rollers 82a, 82b held in rolling contact with the rubber rollers 80a, 80b, respectively. The backup roller 82b is pressed against the rubber roller 80b by pressing cylinders 84a, 84b of a roller clamp unit 83.

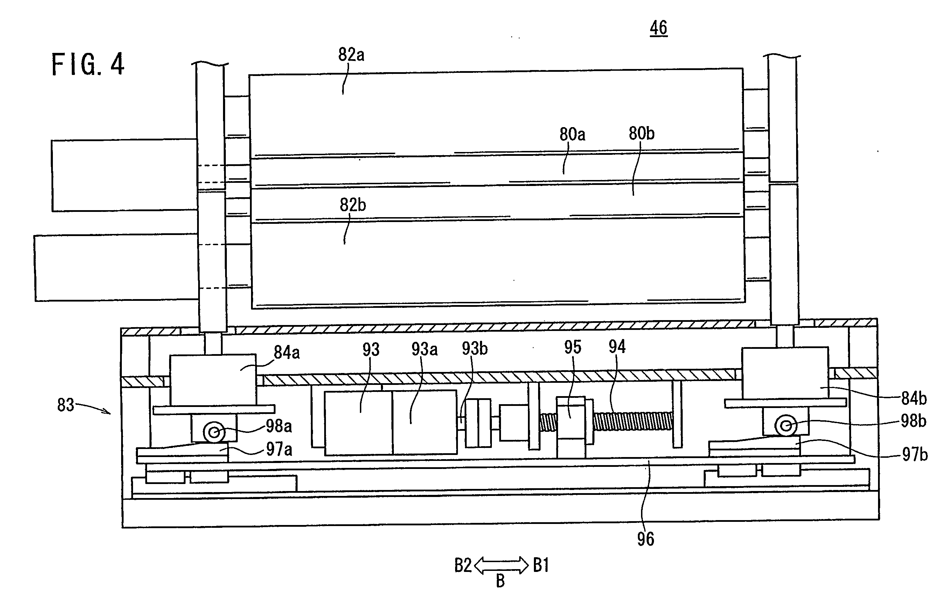

As shown in FIG. 4, the roller clamp unit 83 has a drive motor 93 having a drive shaft coupled to a speed reducer 93a which has a drive shaft 93b coaxially connected to a ball screw 94. A nut 95 is threaded over the ball screw 94 and fixed to a slide base 96. Tapered cams 97a, 97b are fixedly mounted on respective opposite ends of the slide base 96 in the transverse direction of the photosensitive webs 22a, 22b, which is indicated by the arrow B. The tapered cams 97a, 97b are progressively higher in the direction indicated by the arrow B1. Rollers 98a, 98b are placed on the respective tapered cams 97a, 97b and held on the respective lower ends of pressing cylinders 84a, 84b.

As shown in FIG. 1, a contact prevention roller 86 is movably disposed near the rubber roller 80a for preventing the photosensitive webs 22a, 22b from contacting the rubber roller 80a. A preheating unit 87 for preheating the photosensitive webs 22a, 22b to a predetermined temperature is disposed upstream of and closely to the joining mechanism 46. The preheating unit 87 comprises an infrared bar heater or a heat applying means.

Glass substrates 24 are fed from the joining mechanism 46 through the inter-substrate web cutting mechanism 48 along a feed path 88 which extends in the direction indicated by the arrow C. The feed path 88 comprises an array of rollers including film feed rollers 90a, 90b and substrate feed rollers 92 with the web cutting mechanism 48a interposed therebetween. The distance between the rubber rollers 80a, 80b and the substrate feed rollers 92 is equal to or less than the length of one glass substrate 24.

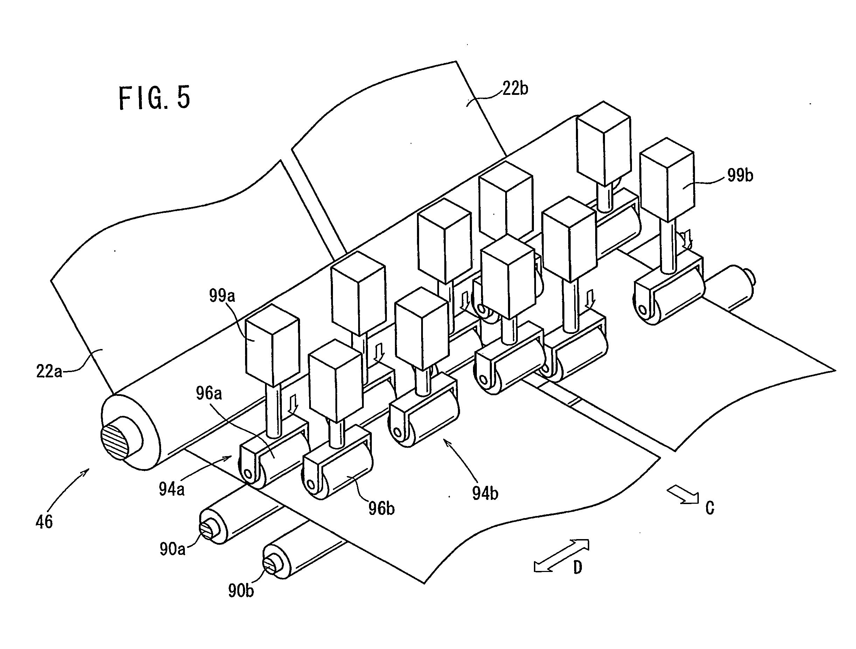

As shown in FIG. 5, the film feed rollers 90a, 90b are elongate transversely across the photosensitive webs 22a, 22b which are fed parallel to each other from the joining mechanism 46. The film feed rollers 90a, 90b are driven to rotate independently of each other. The film feed rollers 90a, 90b are associated with respective nip roller groups 94a, 94b.

The nip roller group 94a comprises a plurality of, e.g., five, nip rollers 96a that are disposed at predetermined intervals along the film feed roller 90a, i.e., in the direction indicated by the arrow D. The nip rollers 96a are individually movable toward and away from the film feed roller 90a by respective cylinders 99a. Similarly, the nip roller group 94b comprises a plurality of, e.g., five, nip rollers 96b that are disposed at predetermined intervals along the film feed roller 90b, i.e., in the direction indicated by the arrow D. The nip rollers 96b are individually movable toward and away from the film feed roller 90b by respective cylinders 99b.

In the manufacturing apparatus 20, the first and second reel-out mechanisms 32a, 32b, the first and second processing mechanisms 36a, 36b, the first and second label bonding mechanisms 40a, 40b, the first and second reservoir mechanisms 42a, 42b, the first and second peeling mechanisms 44a, 44b, the first and second tension control mechanisms 66a, 66b, and the first and second detecting mechanisms 47a, 47b are disposed above the joining mechanism 46. Conversely, the first and second reel-out mechanisms 32a, 32b, the first and second processing mechanisms 36a, 36b, the first and second label bonding mechanisms 40a, 40b, the first and second reservoir mechanisms 42a, 42b, the first and second peeling mechanisms 44a, 44b, the first and second tension control mechanisms 66a, 66b, and the first and second detecting mechanisms 47a, 47b may be disposed below the joining mechanism 46, so that the photosensitive webs 22a, 22b may be rendered upside down such that the photosensitive resin layer 28 is joined to the lower surfaces of glass substrates 24. Alternatively, all the mechanisms of the manufacturing apparatus 20 may be linearly arrayed.

As shown in FIG. 1, the manufacturing apparatus 20 is controlled in its entirety by a lamination process controller 100. The manufacturing apparatus 20 also has a lamination controller 102, a substrate heating controller 104, etc. for controlling the different functional components of the manufacturing apparatus 20. These controllers are interconnected by an in-process network. The lamination process controller 100 is connected to the network of a factory which incorporates the manufacturing apparatus 20, and performs information processing for production, e.g., production management and mechanism operation management, based on instruction information (condition settings and production information) from a factory CPU (not shown).

The substrate heating controller 104 controls the substrate heating units 74 to receive glass substrates 24 from an upstream process and heat the received glass substrates 24 to a desired temperature, controls the feeder 76 to feed the heated glass substrates 24 to the joining mechanism 46, and also controls the handling of information about the glass substrates 24.

The lamination controller 102 serves as process master for controlling the functional components of the manufacturing apparatus 20. The lamination controller 102 operates as a control mechanism for controlling relative positions of the boundary positions and the glass substrate 24 and relative positions of the boundary positions themselves in the joining position based on the positional information, detected by the first and second detecting mechanisms 47a, 47b, of the partly cut regions 34 of the photosensitive webs 22a, 22b.

The installation space of the manufacturing apparatus 20 is divided into a first clean room 112a and a second clean room 112b by a partition wall 110. The first clean room 112a houses therein the first and second reel-out mechanisms 32a, 32b, the first and second processing mechanisms 36a, 36b, the first and second label bonding mechanisms 40a, 40b, the first and second reservoir mechanisms 42a, 42b, the first and second peeling mechanisms 44a, 44b, and the first and second tension control mechanisms 66a, 66b. The second clean room 112b houses therein the first and second detecting mechanisms 47a, 47b and the other components following the first and second detecting mechanisms 47a, 47b. The first clean room 112a and the second clean room 112b are connected to each other by a through region 114.

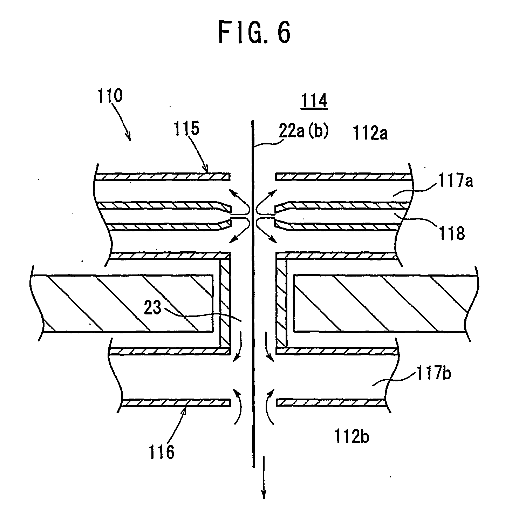

As shown in FIG. 6, the through region 114 has a deduster 115 disposed in the first clean room 112a and an air sealer 116 disposed in the second clean room 112b.

The deduster 115 has a pair of suction nozzles 117a disposed in confronting relation to respective opposite surfaces of the photosensitive webs 22a, 22b, and a pair of ejection nozzles 118 disposed respectively in the suction nozzles 117a. The ejection nozzles 118 eject air to the photosensitive webs 22a, 22b to remove dust particles from the photosensitive webs 22a, 22b, and the suction nozzles 117a draw the ejected air and the removed dust particles. Preferably, the air from the ejection nozzles 118 may be electric neutralizing (or antistatic) air.

The air sealer 116 has a pair of suction nozzles 117b disposed in confronting relation to respective opposite surfaces of the photosensitive webs 22a, 22b. The suction nozzles 117b draw air to seal the through region 114. The deduster 115 and the air sealer 116 may be switched around in position, or a plurality of dedusters 115 and a plurality of air sealers 116 may be combined with each other. Only the suction nozzle 117a, but not the ejection nozzle 118, may be disposed in confronting relation to the side of the photosensitive webs 22a, 22b where the photosensitive resin layers 28 are exposed.

In the manufacturing apparatus 20, the partition wall 110 prevents heated air from the joining mechanism 46 from thermally affecting the photosensitive webs 22a, 22b, i.e., from wrinkling, deforming, thermally shrinking, or stretching the photosensitive webs 22a, 22b. The partition wall 110 separates an upper area of the manufacturing apparatus 20, i.e., the first clean room 112a, where dust particles are liable to occur and fall, from a lower area of the manufacturing apparatus 20, i.e., the second clean room 112b, thereby keeping the joining mechanism 46 in particular clean. It is desirable to keep the pressure in the second clean room 112b higher than the pressure in the first clean room 112a, thereby preventing dust particles from flowing from the first clean room 112a into the second clean room 112b.

An air supply (not shown) for supplying a downward flow of clean air is disposed in an upper portion of the second clean room 112b.

Operation of the manufacturing apparatus 20 for carrying out a manufacturing method according to the present invention will be described below.

Initially for positioning the leading ends of the photosensitive webs 22a, 22b in place, the photosensitive webs 22a, 22b are unreeled from the respective photosensitive web rolls 23a, 23b accommodated in the first and second reel-out mechanisms 32a, 32b. The photosensitive webs 22a, 22b are delivered through the first and second processing mechanisms 36a, 36b, the first and second label bonding mechanisms 40a, 40b, the first and second reservoir mechanisms 42a, 42b, the first and second peeling mechanisms 44a, 44b, and the joining mechanism 46 to the film feed rollers 90a, 90b.

As shown in FIG. 5, of the nip roller group 94a, three nip rollers 96a which are positioned over the wider photosensitive web 22a (closer to the viewer) are displaced toward the film feed roller 90a by the respective cylinders 99a until the wider photosensitive web 22a is sandwiched between the three nip rollers 96a and the film feed roller 90a.

Of the nip roller group 94b, two nip rollers 96b which are positioned over the narrower photosensitive web 22b (remoter from the viewer) are displaced toward the film feed roller 90b by the respective cylinders 99b until the narrower photosensitive web 22b is sandwiched between the two nip rollers 96b and the film feed roller 90b.

The remaining two nip rollers 96a (remoter from the viewer) of the nip roller group 94a are spaced away from the film feed roller 90a, and the remaining three nip rollers 96b (closer to the viewer) of the nip roller group 94b are spaced away from the film feed roller 90b.

When a partly cut region 34 of the photosensitive web 22a is detected by the photoelectric sensor 72a of the first detecting mechanism 47a, the film feed roller 90a is rotated based on a detected signal from the photoelectric sensor 72a. The photosensitive web 22a is now fed a predetermined distance to the joining position by the film feed roller 90a and the three nip rollers 96a which sandwich the photosensitive web 22a therebetween.

When a partly cut region 34 of the photosensitive web 22b is detected by the photoelectric sensor 72b of the second detecting mechanism 47b, the film feed roller 90b is rotated based on a detected signal from the photoelectric sensor 72b. The photosensitive web 22b is now fed a predetermined distance to the joining position by the film feed roller 90b and the two nip rollers 96b which sandwich the photosensitive web 22b therebetween. The partly cut regions 34 of the photosensitive webs 22a, 22b are now positioned in the joining position. The partly cut regions 34 of the photosensitive webs 22a, 22b may be detected downstream of the joining position, and the photosensitive webs 22a, 22b may be stopped at a given position.

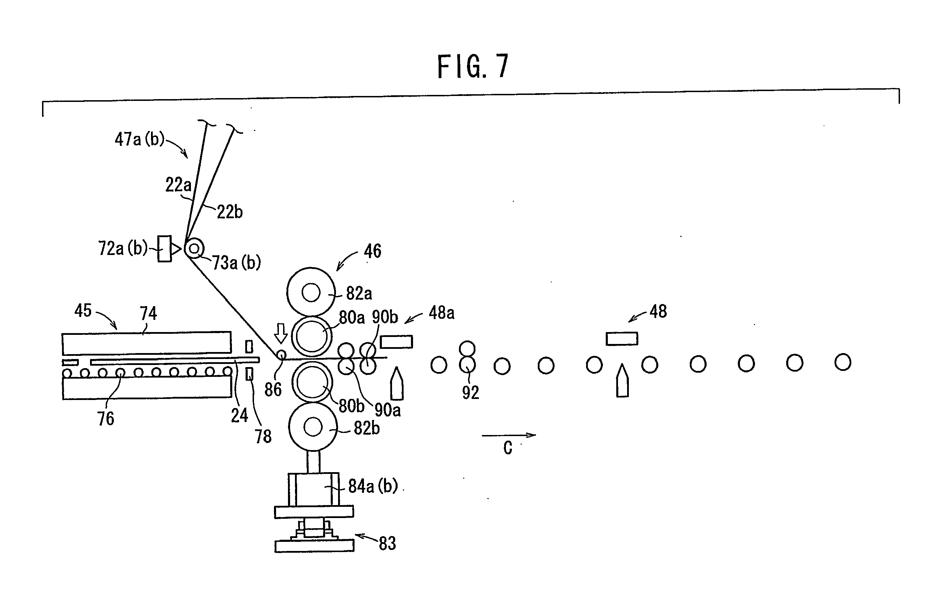

After the photosensitive webs 22a, 22b have been fed the predetermined distance, as shown in FIG. 7, the contact prevention roller 86 is lowered to prevent the photosensitive webs 22a, 22b from contacting the rubber roller 80a. A glass substrate 24 is waiting immediately prior to the joining position. The photosensitive webs 22a, 22b are now in an initial state of the manufacturing apparatus 20.

Operation of the functional components of the manufacturing apparatus 20 in a lamination mode will be described below.

As shown in FIG. 1, in the first and second processing mechanisms 36a, 36b, the circular blades 52 move transversely across the photosensitive webs 22a, 22b to cut into the protective films 30, the photosensitive resin layers 28, and the base films 26, thereby forming partly cut regions 34 (see FIG. 2). Then, the photosensitive webs 22a, 22b are fed again a distance corresponding to the dimension of the residual sections 30b of the protective films 30 in the direction indicated by the arrow A (see FIG. 1), and then stopped, whereupon other partly cut regions 34 are formed therein by the circular blades 52. As shown in FIG. 2, a front peel-off section 30aa and a rear peel-off section 30ab are now provided in each of the photosensitive webs 22a, 22b, with the residual section 30b interposed therebetween.

Then, the photosensitive webs 22a, 22b are fed to the first and second label bonding mechanisms 40a, 40b to place respective predetermined bonding areas of the protective films 30 on the support bases 56. In the first and second label bonding mechanisms 40a, 40b, a predetermined number of adhesive labels 38 are attracted under suction and held by the suction pads 54b through 54e and are securely bonded to the front peel-off section 30aa and the rear peel-off section 30ab of the protective film 30 across the residual section 30b thereof (see FIG. 3).

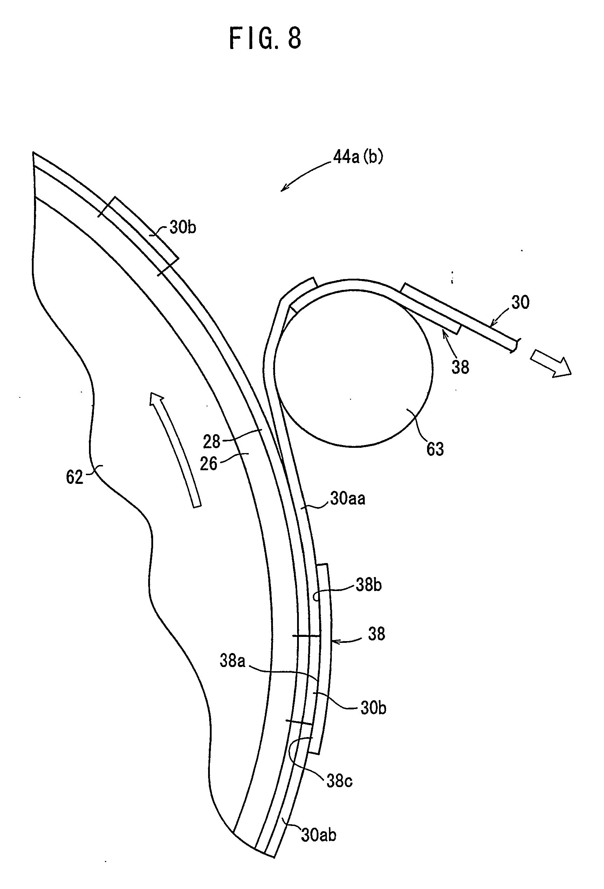

The photosensitive webs 22a, 22b with the five adhesive labels 38 bonded thereto, for example, are isolated by the first and second reservoir mechanisms 42a, 42b from variations of the tension to which the supplied photosensitive webs 22a, 22b are subjected, and then continuously fed to the first and second peeling mechanisms 44a, 44b. In the first and second peeling mechanisms 44a, 44b, as shown in FIG. 8, the base films 26 of the photosensitive webs 22a, 22b are attracted to the suction drum 62, and the protective films 30 are peeled off from the photosensitive webs 22a, 22b, leaving the residual sections 30b. The protective films 30 are peeled off at a sharp peel-off angle and wound by the protective film takeup units 64 (see FIG. 1). Preferably, electric neutralizing air may be blown on the peeled portions.

At this time, inasmuch as the photosensitive webs 22a, 22b are firmly held by the suction drum 62, shocks produced when the protective films 30 are peeled off from the photosensitive webs 22a, 22b are not transferred to the photosensitive webs 22a, 22b downstream of the suction drum 62. Consequently, such shocks are not transferred to the joining mechanism 46, and hence laminated sections of glass substrates 24 are effectively prevented from developing a striped defective region.

After the protective films 30 have been peeled off from the base films 26, leaving the residual sections 30b, by the first and second peeling mechanisms 44a, 44b, the photosensitive webs 22a, 22b are adjusted in tension by the first and second tension control mechanisms 66a, 66b, and then partly cut regions 34 of the photosensitive webs 22a, 22b are detected by the photoelectric sensors 72a, 72b of the first and second detecting mechanisms 47a, 47b.

Based on detected information of the partly cut regions 34, the film feed rollers 90a, 90b are rotated to feed the photosensitive webs 22a, 22b a predetermined length to the joining mechanism 46. At this time, the contact prevention roller 86 is waiting above the photosensitive webs 22a, 22b and the rubber roller 80b is disposed below the photosensitive webs 22a, 22b.

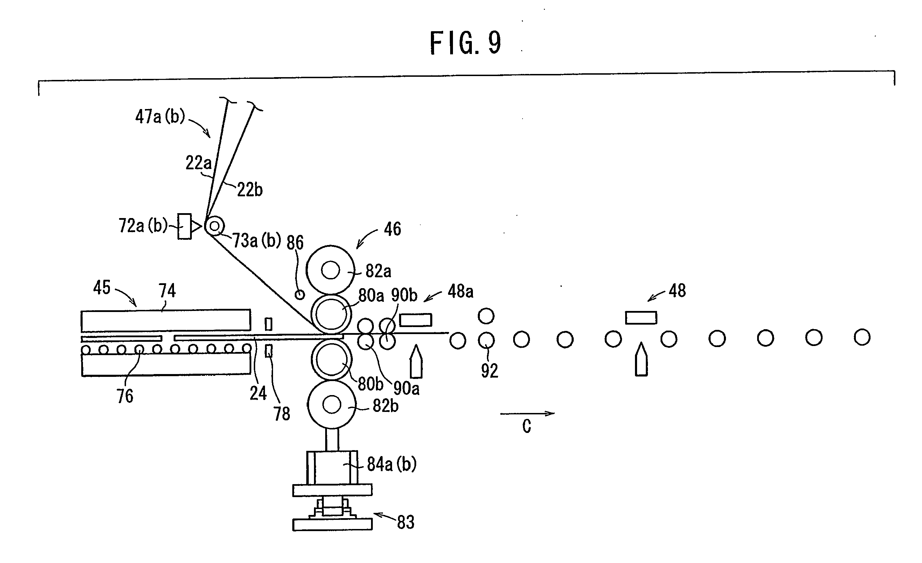

As shown in FIG. 9, the first glass substrate 24 which is preheated is fed to the joining position by the substrate feed mechanism 45. The glass substrate 24 is tentatively positioned between the rubber rollers 80a, 80b in alignment with the joined photosensitive resin layers 28 of the photosensitive webs 22a, 22b which lie parallel to each other.

Then, as shown in FIG. 4, the ball screw 94 is rotated in a certain direction by the speed reducer 93a coupled to the drive motor 93, moving the slide base 96 in the direction indicated by the arrow B2 in unison with the nut 95 threaded over the ball screw 94. Therefore, the tapered cams 97a, 97b have their cam surfaces in contact with the rollers 98a, 98b raised, displacing the rollers 98a, 98b upwardly. The pressing cylinders 84a, 84b are elevated, lifting the backup roller 82b and the rubber roller 80b to sandwich the glass substrate 24 under a predetermined pressing pressure between the rubber rollers 80a, 80b. At this time, the pressing pressure is adjusted by the pressure of air supplied to the pressing cylinders 84a, 84b. The rubber roller 80a is rotated to transfer, i.e., laminate, the parallel photosensitive resin layers 28, which are melted with heat, to the glass substrate 24.

The photosensitive resin layers 28 are laminated onto the glass substrate 24 under such conditions that the photosensitive resin layers 28 are fed at a speed in the range from 1.0 m/min. to 10 m/min., the rubber rollers 80a, 80b have a temperature ranging from 100°C to 150°C, and a hardness ranging from 40 to 90, and apply a pressure (linear pressure) ranging from 50 N/cm to 400 N/cm.

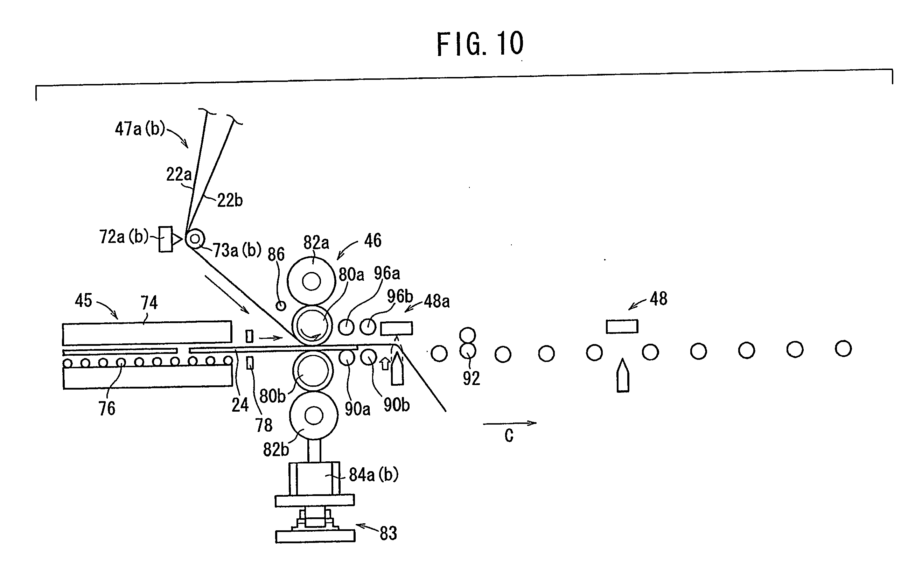

As shown in FIG. 10, when the leading end of the glass substrate 24 reaches a position near the film feed rollers 90a, 90b, the nip rollers 96a, 96b are moved away from the film feed rollers 90a, 90b. When the leading ends of the photosensitive webs 22a, 22b which project forwardly of the glass substrate 24 in the direction indicated by the arrow C reach a predetermined position with respect to the web cutting mechanism 48a, the web cutting mechanism 48a is actuated to cut off the leading ends of the photosensitive webs 22a, 22b, as indicated by the broken lines in FIG. 10. The web cutting mechanism 48a returns to its standby position except for the time of cutting off the leading ends of the photosensitive webs 22a, 22b, the time of operation termination, and the time of cutting off the photosensitive webs 22a, 22b in case of trouble. The web cutting mechanism 48a will not be used while the manufacturing apparatus 20 is in normal operation.

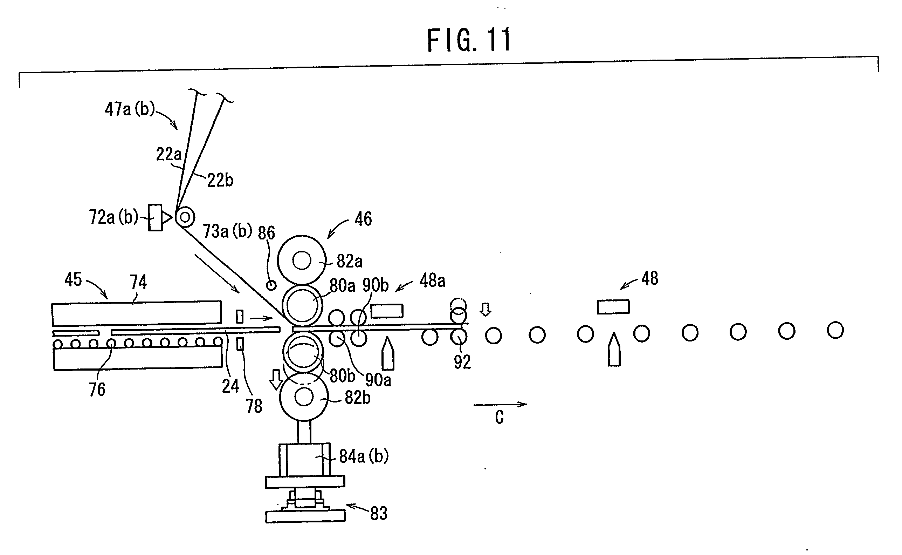

As shown in FIG. 11, when the photosensitive webs 22a, 22b have been laminated onto the glass substrate 24 up to its trailing end by the rubber rollers 80a, 80b, the rubber roller 80a is stopped against rotation, and the glass substrate 24 with the laminated photosensitive webs 22a, 22b (also referred to as "joined substrate 24a") is clamped by the substrate feed rollers 92.

The rubber roller 80b is retracted away from the rubber roller 80a, unclamping the joined substrate 24a. Specifically, as shown in FIG. 4, the speed reducer 93a coupled to the drive motor 93 is reversed, causing the ball screw 94 and the nut 95 to move the slide base 96 in the direction indicated by the arrow B1. Therefore, the tapered cams 97a, 97b have their cam surfaces in contact with the rollers 98a, 98b lowered, displacing the pressing cylinders 84a, 84b downwardly. The backup roller 82b and the rubber roller 80b are lowered, unclamping the joined substrate 24a.

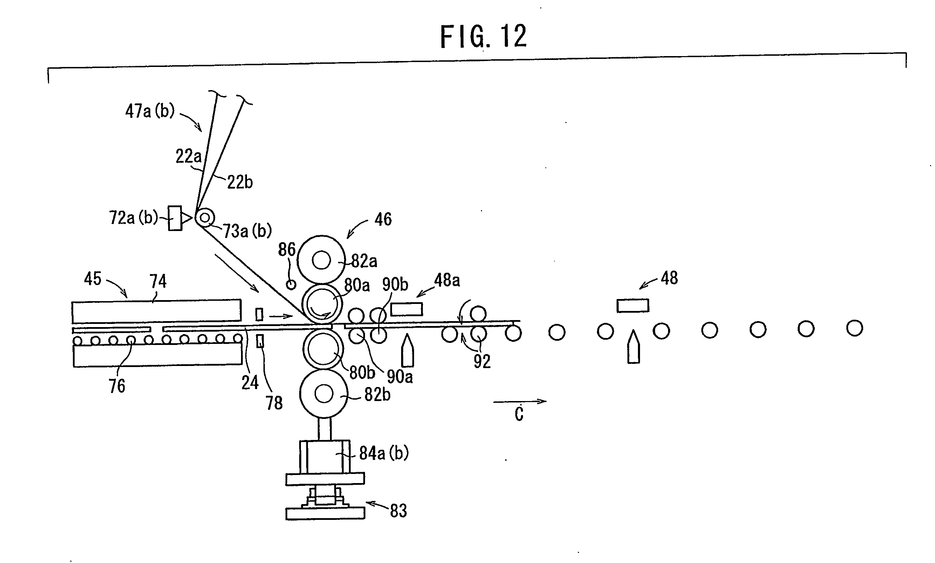

The substrate feed rollers 92 then start rotating to feed the joined substrate 24a a predetermined distance in the direction indicated by the arrow C. The position of the photosensitive webs 22a, 22b which is to be brought between two adjacent glass substrates 24 is now displaced to a position beneath the rubber roller 80a. A next glass substrate 24 is fed toward the joining position by the substrate feed mechanism 45. When the leading end of the next glass substrate 24 is positioned between the rubber rollers 80a, 80b, the rubber roller 80b is lifted, clamping the next glass substrate 24 and the photosensitive webs 22a, 22b between the rubber rollers 80a, 80b. The rubber rollers 80a, 80b and the substrate feed roller 92 are rotated to start laminating the photosensitive webs 22a, 22b onto the glass substrate 24 and feed a joined substrate 24a in the direction indicated by the arrow C (see FIG. 12).

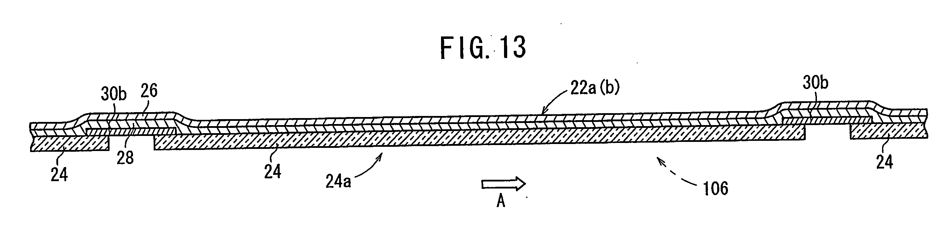

At this time, as shown in FIG. 13, the joined substrate 24a has opposite ends covered with respective residual sections 30b. Therefore, when the photosensitive resin layers 28 are transferred to the glass substrate 24, the rubber rollers 80a, 80b are not smeared by the photosensitive resin layers 28.

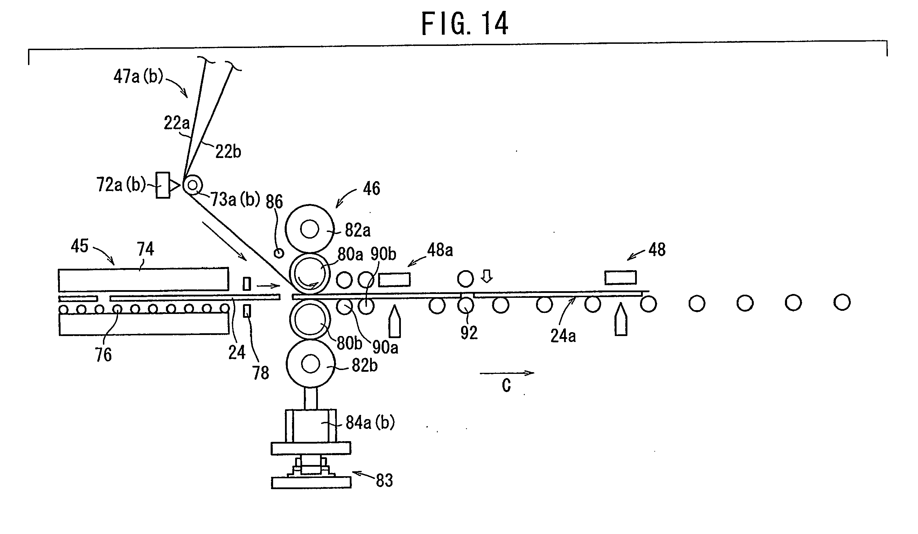

As shown in FIG. 14, when the trailing end of the first joined substrate 24a reaches the substrate feed rollers 92, the upper one of the substrate feed rollers 92 is lifted to unclamp the first joined substrate 24a, and the lower one of the substrate feed rollers 92 and the other rollers of the feed path 88 are continuously rotated to feed the joined substrate 24a. When the trailing end of the next, i.e., second, joined substrate 24a reaches a position near the rubber rollers 80a, 80b, the rubber rollers 80a, 80b and the substrate feed rollers 92 are stopped against rotation. The upper one of the substrate feed rollers 92 is lowered to clamp the second joined substrate 24a, and the rubber roller 80b is lowered to unclamp the second joined substrate 24a. Then, the substrate feed rollers 92 are rotated to feed the second joined substrate 24a. The position of the photosensitive webs 22a, 22b which is to be brought between two adjacent glass substrates 24 is now displaced to the position beneath the rubber roller 80a, and the photosensitive webs 22a, 22b are repeatedly laminated onto a third glass substrate 24.

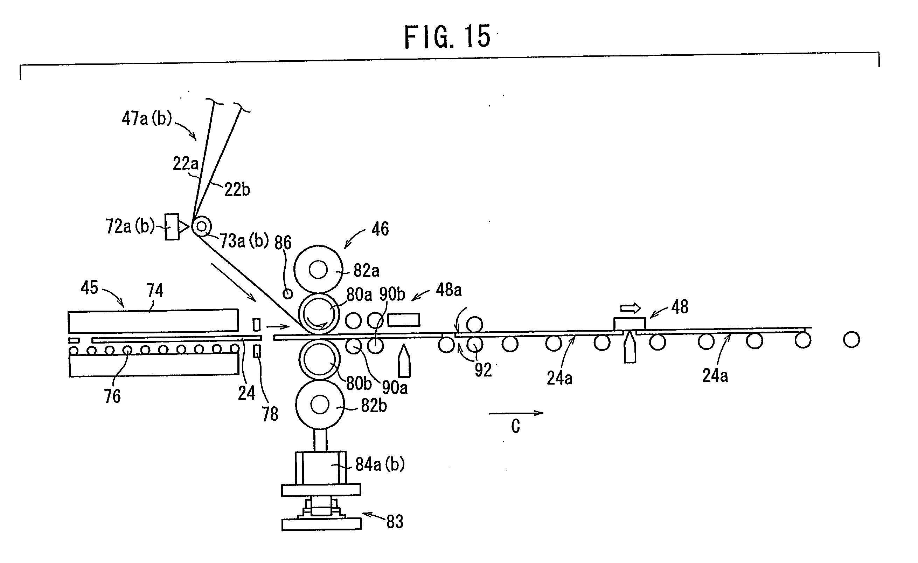

As shown in FIG. 15, when the position between two adjacent joined substrates 24a reaches a position corresponding to the inter-substrate web cutting mechanism 48, the inter-substrate web cutting mechanism 48 severs the two photosensitive webs 22a, 22b together between the joined substrates 24a while moving in the direction indicated by the arrow C at the same speed as the joined substrates 24a. Thereafter, the inter-substrate web cutting mechanism 48 returns to a standby position, and the base films 26 and the residual sections 30b are peeled off from the leading joined substrate 24a, thereby manufacturing a photosensitive laminated body 106 (see FIG. 1).

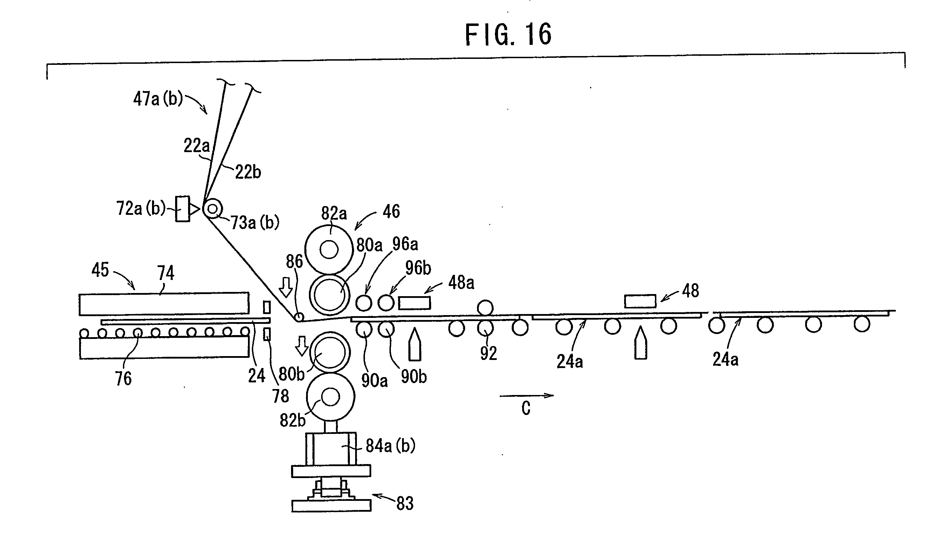

When the laminating process is temporarily stopped, as shown in FIG. 16, the nip roller groups 94a, 94b and the rubber roller 80b are brought into unclamping positions, and the contact prevention roller 86 is lowered to prevent the two photosensitive webs 22a, 22b from contacting the rubber roller 80a.

When the manufacturing apparatus 20 is to be shut off, the substrate feed rollers 92 are rotated to feed the joined substrate 24a in the direction indicated by the arrow C, and the web cutting mechanism 48a clamps the photosensitive webs 22a, 22b. While the film feed rollers 90a, 90b in rotation are clamping the photosensitive webs 22a, 22b, the web cutting mechanism 48a travels transversely across the photosensitive webs 22a, 22b, cutting off the photosensitive webs 22a, 22b.

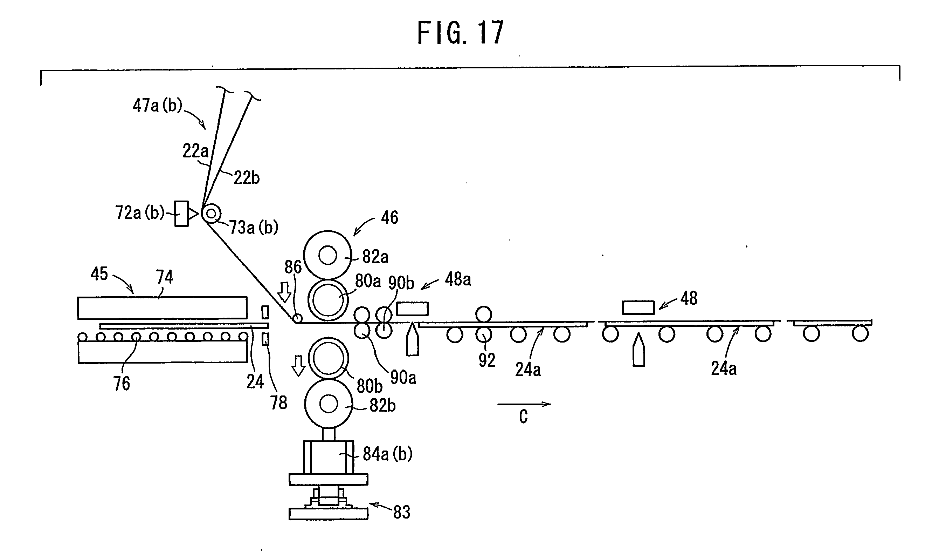

Consequently, as shown in FIG. 17, the two photosensitive webs 22a, 22b pass between the rubber rollers 80a, 80b and are sandwiched by the film feed rollers 90a, 90b, and are supported away from the rubber roller 80a by the contact prevention roller 86 which is lowered. The web cutting mechanism 48a has been placed in its standby position.

When the inter-substrate web cutting mechanism 48 and the web cutting mechanism 48a cut off the photosensitive webs 22a, 22b, they move in synchronism with the photosensitive webs 22a, 22b in the direction indicated by the arrow C. However, the inter-substrate web cutting mechanism 48 and the web cutting mechanism 48a may move only transversely across the photosensitive webs 22a, 22b to cut off the photosensitive webs 22a, 22b. The photosensitive webs 22a, 22b may be cut off by a Thompson blade while they are held at rest, or may be cut off by a rotary blade while they are in motion.

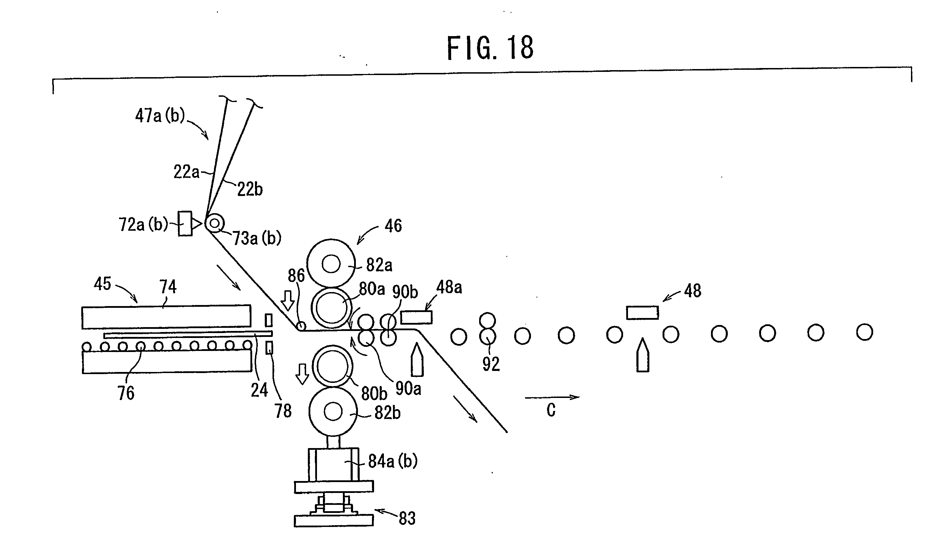

When the manufacturing apparatus 20 operates in its initial state, as shown in FIG. 18, the contact prevention roller 86 is disposed in the lower position and the rubber roller 80b is spaced away from the rubber roller 80a. Then, the film feed roller 90a is rotated to discharge the photosensitive webs 22a, 22b into a web disposal container (not shown). At this time, the photosensitive webs 22a, 22b are severed into a certain length by the web cutting mechanism 48a.

When the first and second detecting mechanisms 47a, 47b detect partly cut regions 34 of the photosensitive webs 22a, 22b, the photosensitive webs 22a, 22b are fed a predetermined length from the detected position. Specifically, when the contact prevention roller 86 is elevated, the photosensitive webs 22a, 22b are fed until the partly cut regions 34 reach a position where the photosensitive webs 22a, 22b are to be laminated by the rubber rollers 80a, 80b. The leading ends of the photosensitive webs 22a, 22b are now positioned in place.

In the first embodiment, the partly cut regions 34 of the photosensitive webs 22a, 22b are directly detected by the respective first and second detecting mechanisms 47a, 47b upwardly of and closely to the joining mechanism 46. The distance from the first and second detecting mechanisms 47a, 47b to the position where the partly cut regions 34 are stopped by the rubber rollers 80a, 80b needs to be smaller than the shortest length of the photosensitive webs 22a, 22b to be laminated. This is because the information of the detected partly cut regions 34 is used for a next laminating process through feedback.

The first and second detecting mechanisms 47a, 47b perform two measuring processes as described below. According to the first measuring process, the rubber rollers 80a, 80b clamp the glass substrate 24, and the number of pulses generated by an encoder combined with a drive motor (not shown) for rotating the rubber rollers 80a, 80b, as representing the distance by which the glass substrate 24 is fed from the start of rotation of the rubber rollers 80a, 80b, is compared with the preset numbers of pulses generated when the respective partly cut regions 34 are to be detected by the first and second detecting mechanisms 47a, 47b, thereby measuring displacements of the partly cut regions 34. If the partly cut region 34 of each of the photosensitive webs 22a, 22b is detected before the preset number of pulses is reached, then the partly cut region 34 is judged as being displaced forwardly of a predetermined position on the glass substrate 24 by a distance indicated by the difference between the numbers of pulses. Conversely, if the partly cut region 34 of each of the photosensitive webs 22a, 22b is detected after the preset number of pulses is reached, then the partly cut region 34 is judged as being displaced rearwardly of a predetermined position on the glass substrate 24.

According to the second measuring process, the number of pulses generated by an encoder combined with a drive motor (not shown) for rotating the rubber rollers 80a, 80b is measured from the detection of a partly cut region 34 to the detection of a next partly cut region 34, thereby measuring the laminated length of each of the photosensitive webs 22a, 22b. The preset number of pulses corresponding to the laminated length under normal conditions of each of the photosensitive webs 22a, 22b is compared with the actually measured number of pulses. If the actually measured number of pulses is greater than the preset number of pulses, then the photosensitive webs 22a, 22b are judged as being stretched due to heat or the like by a distance indicated by the difference between the numbers of pulses. If the actually measured number of pulses is smaller than the preset number of pulses, then the photosensitive webs 22a, 22b are judged as being short.

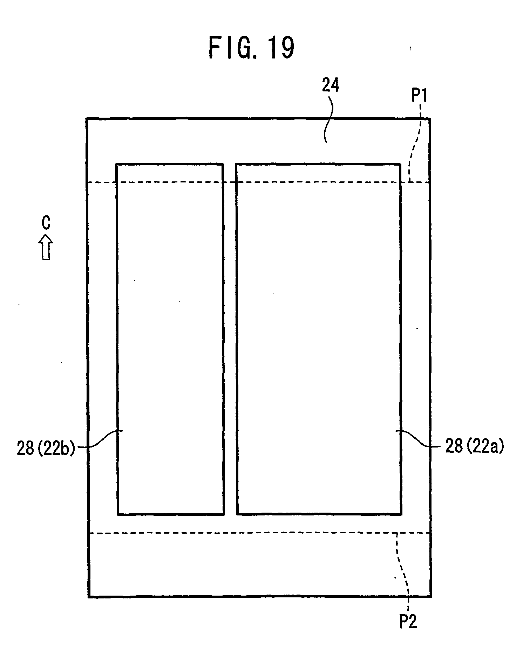

If the leading ends of the photosensitive resin layers 28 are detected as being displaced (advanced) equal distances or substantially equal distances with respect to a joined range P1 - P2 of the glass substrate 24 according to the first measuring process, as shown in FIG. 19, then the relative positions of the glass substrate 24 and the partly cut regions 34 of the photosensitive webs 22a, 22b are adjusted.

Specifically, if the partly cut regions 34 detected by the photoelectric sensors 72a, 72b are detected as being advanced from a predetermined position, then as shown in FIG. 11, the substrate feed rollers 92 feed unjoined portions of the photosensitive webs 22a, 22b after being laminated by a distance represented by the difference between the preset distance and the advanced distance. As a result, the partly cut regions 34 are positionally adjusted and placed in a predetermined position between the rubber rollers 80a, 80b. Thereafter, the glass substrate 24 is delivered under normal delivery control between the rubber rollers 80a, 80b, and the photosensitive resin layers 28 are joined at a normal position to the glass substrate 24, i.e., in the joined range P1 - P2 of the glass substrate 24.

If the partly cut regions 34 detected by the photoelectric sensors 72a, 72b are detected as being delayed from the joined range P1 - P2 of the glass substrate 24, then the substrate feed rollers 92 feed unjoined portions of the photosensitive webs 22a, 22b after being laminated by a distance represented by the sum of the preset distance and the delayed distance. As a result, the partly cut regions 34 are positionally adjusted and placed in a predetermined position between the rubber rollers 80a, 80b. Thereafter, the glass substrate 24 is delivered under normal delivery control between the rubber rollers 80a, 80b, and the photosensitive resin layers 28 are joined at a normal position to the glass substrate 24, i.e., in the joined range P1 - P2 of the glass substrate 24.

Rather than adjusting the distance that the joined substrate 24a is fed by the substrate feed rollers 92, the substrate feed mechanism 45 may be controlled to adjust the position at which the glass substrate 24 is to be stopped, by the advanced or delayed distance.

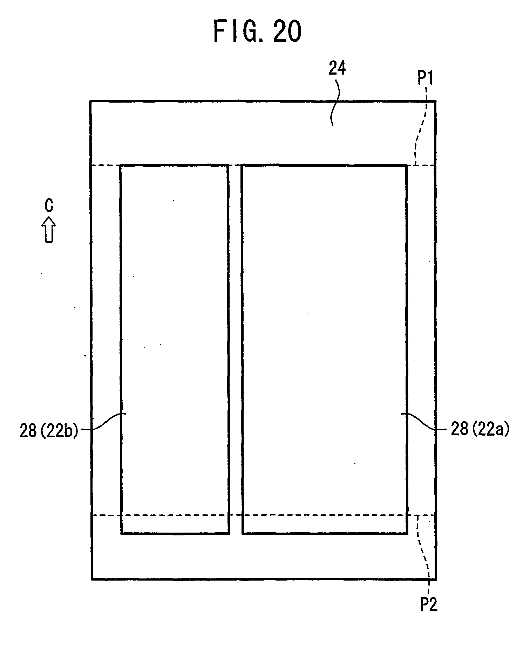

The distances between the partly cut regions 34 detected by the photoelectric sensors 72a, 72b, i.e., the lengths H of the photosensitive resin layers 28 to be joined to the glass substrate 24, are measured according to the second measuring process. If the lengths H are greater than the joined range P1 - P2 by equal lengths or substantially equal lengths (see FIG. 20), then the positions of the partly cut regions 34 are changed by the first and second processing mechanisms 36a, 36b so that the distances between the partly cut regions 34, i.e., the lengths H, are reduced by the differences. If the lengths H are smaller than the joined range P1 - P2, then the positions of the partly cut regions 34 are changed by the first and second processing mechanisms 36a, 36b so that the distances between the partly cut regions 34, i.e., the lengths H, are increased by the differences. In this manner, the joined lengths of the photosensitive resin layers 28 are adjusted to a predetermined length.

It is also possible to change the amount of stretch of the photosensitive webs 22a, 22b by adjusting the tension of the photosensitive webs 22a, 22b with the tension dancers 70 of the first and second tension control mechanisms 66a, 66b.

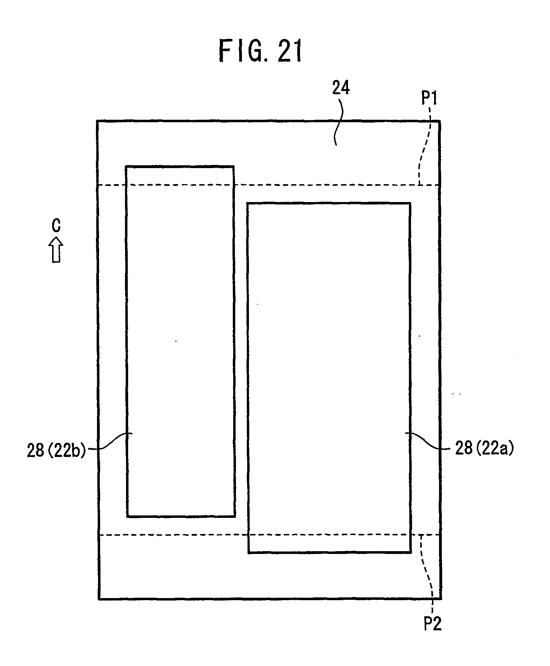

If the leading ends of the photosensitive resin layers 28 of the photosensitive webs 22a, 22b are judged as being displaced from the joined range P1 - P2 of the glass substrate 24 according to the first measuring process, as shown in FIG. 21, then the glass substrate 24 is unclamped from the rubber rollers 80a, 80b immediately after the photosensitive webs 22a, 22b have been laminated onto the glass substrate 24, and then the substrate feed rollers 92 feed the joined substrate 24a to feed the photosensitive webs 22a, 22b to a position where the photosensitive webs 22a, 22b can be cut off. After the photosensitive webs 22a, 22b are cut off, the photosensitive webs 22a, 22b are positioned using the respective film feed rollers 90a, 90b.

The photosensitive resin layers 28 to be joined to the glass substrate 24 may be adjusted in position by positionally adjusting one or both of the partly cut regions 34 of the photosensitive webs 22a, 22b. At this time, the relative positions of the glass substrate 24 and the photosensitive resin layers 28 may be set to position the joined range P1 - P2 in alignment with the intermediate position of the displacement of the photosensitive resin layers 28 in the direction indicated by the arrow C until the displacement is corrected. The relative positions may be set by adjusting the feed by the substrate feed rollers 92 of the unjoined portion of the photosensitive web 22a or 22b after being laminated or by adjusting the stopped position of the glass substrate 24 under the control of the substrate feed mechanism 45.

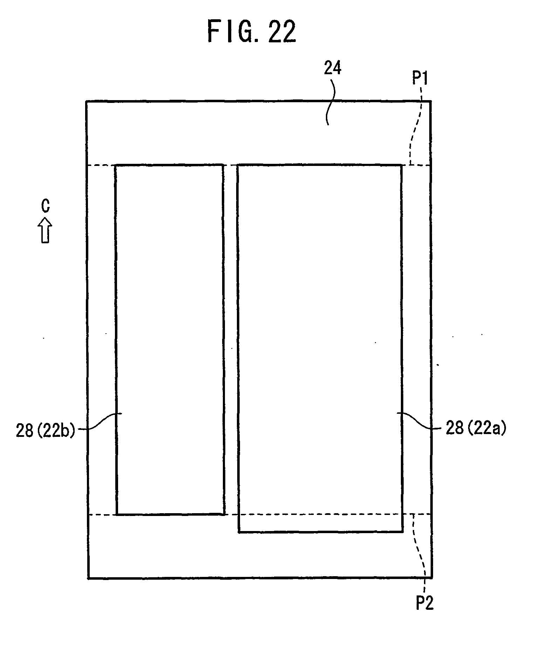

If the length of the photosensitive resin layer 28 of the photosensitive web 22a and the length of the photosensitive resin layer 28 of the photosensitive web 22b are judged as being different from each other according to the second measuring process, as shown in FIG. 22, then the position of one or both of the partly cut regions 34 of the photosensitive webs 22a, 22b may be adjusted. Alternatively, rather than adjusting the position of one or both of the partly cut regions 34, the tension of the photosensitive webs 22a, 22b may be adjusted by the first and second tension control mechanisms 66a, 66b.

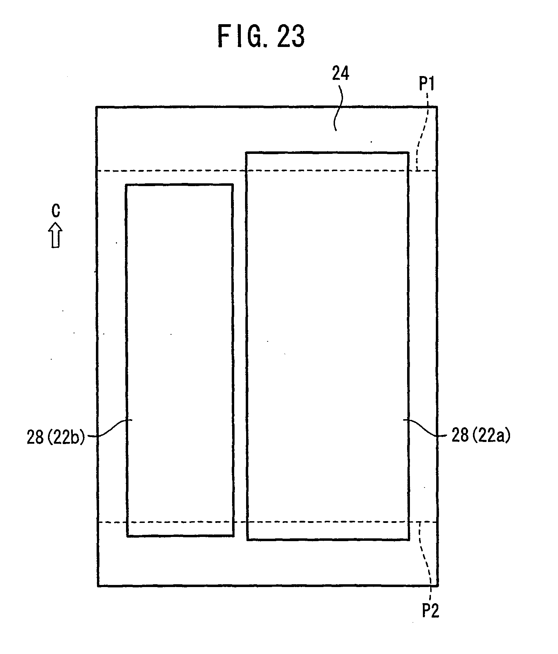

If the lengths and positions of the leading ends of the photosensitive resin layers 28 are judged as being different from each other according to the first and second measuring processes, as shown in FIG. 23, then the joined substrate 24a is unclamped from the rubber rollers 80a, 80b immediately after the photosensitive webs 22a, 22b have been laminated, and thereafter fed to a position where the photosensitive webs 22a, 22b can be cut off. After the photosensitive webs 22a, 22b have been cut off, the photosensitive webs 22a, 22b are positionally aligned by the film feed rollers 90a, 90b. The lengths of the photosensitive resin layers 28 may also be equalized by adjusting the position of one or both of the partly cut regions 34 of the photosensitive webs 22a, 22b or by adjusting the tension of the photosensitive webs 22a, 22b with the first and second tension control mechanisms 66a, 66b.

The transverse positions of the photosensitive webs 22a, 22b can be controlled by the film end position detectors 51 and film end position adjusting mechanisms (not shown). The transverse position of the glass substrate 24 can be corrected by a transverse position adjusting mechanism (not shown) which is disposed immediately before the joining position.

Consequently, the partly cut regions 34 of the photosensitive webs 22a, 22b can be positioned highly accurately with respect to the joining position, allowing the photosensitive resin layers 28 of the photosensitive webs 22a, 22b to be joined parallel to each other accurately in a desired area of the glass substrate 24. It is thus possible to efficiently manufacture a high-quality photosensitive laminated body 106 through a simple process and arrangement.

According to the first embodiment, since two photosensitive resin layers 28 that are transversely spaced from each other can well be transferred onto the wide glass substrate 24, the photosensitive webs 22a, 22b do not need to be wide per se. Therefore, the photosensitive webs 22a, 22b can be handled with increased ease, so that the overall manufacturing process can be performed efficiently and the expenses of the manufacturing facility can be reduced easily.

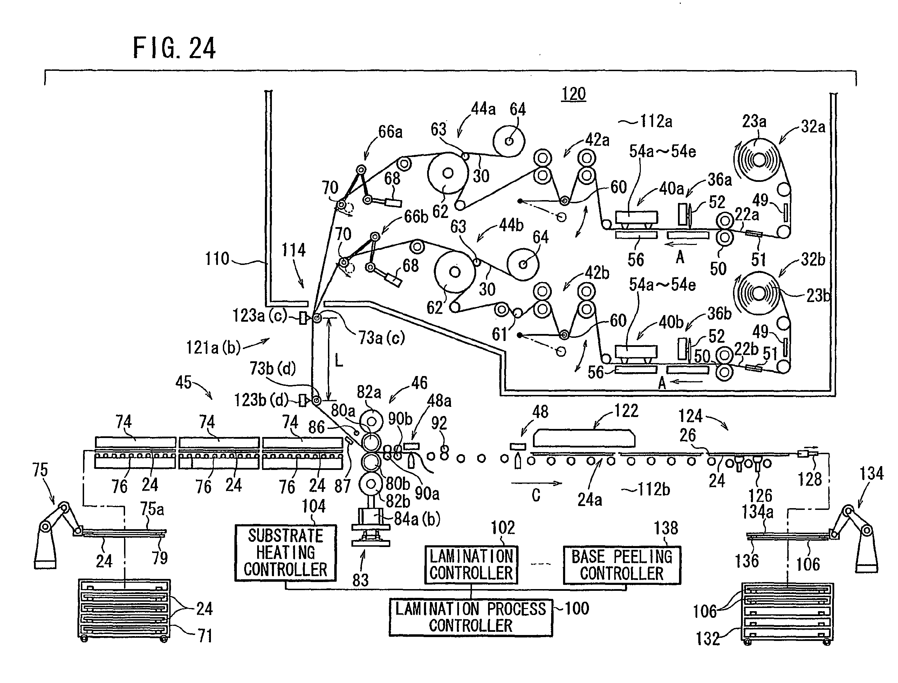

FIG. 24 schematically shows in side elevation a manufacturing apparatus 120 according to a second embodiment of the present invention. Those parts of the manufacturing apparatus 120 according to the second embodiment which are identical to those of the manufacturing apparatus 20 according to the first embodiment are denoted by identical reference characters, and will not be described in detail below.

As shown in FIG. 24, the manufacturing apparatus 120 has first and second detecting mechanisms 121a, 121b, a cooling mechanism 122 disposed downstream of the inter-substrate web cutting mechanism 48, and a base peeling mechanism 124 disposed downstream of the cooling mechanism 122. The first and second detecting mechanisms 121a, 121b have photoelectric sensors 123a, 123b and photoelectric sensors 123c, 123d, respectively, which are spaced from each other by a predetermined distance L and disposed in confronting relation to backup rollers 73a, 73c and backup rollers 73b, 73d, respectively.

The cooling mechanism 122 supplies cold air to a joined substrate 24a to cool the joined substrate 24a after the photosensitive webs 22a, 22b are cut off between the joined substrate 24a and a following joined substrate 24a by the inter-substrate web cutting mechanism 48. Specifically, the cooling mechanism 122 supplies cold air having a temperature of 10°C at a rate ranging from 1.0 to 2.0 m/min.

The base peeling mechanism 124 disposed downstream of the cooling mechanism 122 has a plurality of suction pads 126 for attracting the lower surface of a joined substrate 24a. While the joined substrate 24a is being attracted under suction by the suction pads 126, the base films 26 and the residual sections 30b are peeled off from the joined substrate 24a by a robot hand 128. Electric neutralizing blowers (not shown) for ejecting ion air to four sides of the laminated area of the joined substrate 24a are disposed upstream, downstream, and laterally of the suction pads 126. The base films 26 and the residual sections 30b may be peeled off from the joined substrate 24a while a table for supporting the joined substrate 24a thereon is being oriented vertically, obliquely, or turned upside down for dust removal.

The base peeling mechanism 124 is followed downstream by a photosensitive laminated body storage frame 132 for storing a plurality of photosensitive laminated bodies 106. A photosensitive laminated body 106 that is produced when the base films 26 and the residual sections 30b are peeled off from the joined substrate 24a by the base peeling mechanism 124 is attracted by suction pads 136 on a hand 134a of a robot 134, taken out from the base peeling mechanism 124, and placed into the photosensitive laminated body storage frame 132.

To the lamination process controller 100, there are connected the lamination controller 102, the substrate heating controller 104, and also a base peeling controller 138. The base peeling controller 138 controls the base peeling mechanism 124 to peel off the base film 26 from the joined substrate 24a that is supplied from the joining mechanism 46, and also to discharge the photosensitive laminated body 106 to a downstream process. The base peeling controller 138 also handles information about the joined substrate 24a and the photosensitive laminated body 106.

In the first and second detecting mechanisms 121a, 121b according to the second embodiment, the photoelectric sensors 123a, 123c which are positioned upstream of the photoelectric sensors 123b, 123d first detect the partly cut regions 34 of the photosensitive webs 22a, 22b. Thereafter, the downstream photoelectric sensors 123b, 123d detect the partly cut regions 34 of the photosensitive webs 22a, 22b. The distance L between the backup rollers 73a, 73c and the backup rollers 73b, 73d corresponds to the length of each of the photosensitive resin layers 28 applied to the glass substrate 24.

The actual applied lengths of the photosensitive resin layers 28 can accurately be calculated from the difference between the time when the upstream photoelectric sensors 123a, 123c detect the partly cut regions 34 of the photosensitive webs 22a, 22b and the time when the downstream photoelectric sensors 123b, 123d detect the same partly cut regions 34 of the photosensitive webs 22a, 22b. Based on the calculated actual applied lengths of the photosensitive resin layers 28, the speeds at which the photosensitive webs 22a, 22b are fed are adjusted to apply the photosensitive resin layers 28 centrally to the glass substrate 24.

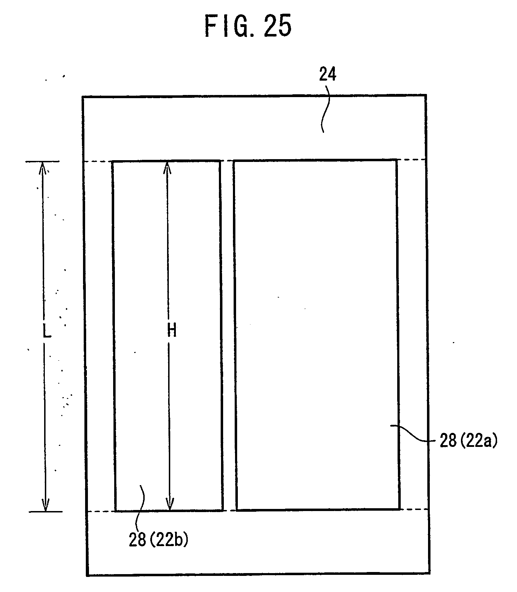

According to the second embodiment, therefore, the distance between the partly cut regions 34 of the photosensitive webs 22a, 22b, i.e., the length H of each of the photosensitive resin layers 28 applied to the glass substrate 24, is accurately detected to apply the photosensitive resin layers 28 centrally to the glass substrate 24 (see FIG. 25).

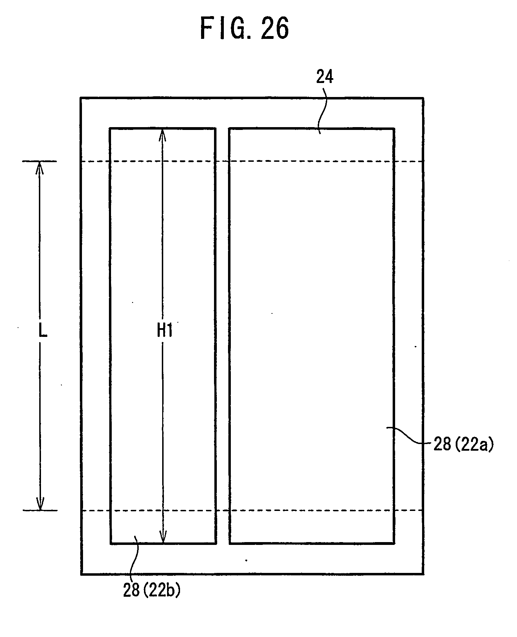

If the length H1 of each of the photosensitive resin layers 28 which is detected by the first and second detecting mechanisms 121a, 121b is larger than the normal length H, as shown in FIG. 26, then the photosensitive resin layers 28 are applied centrally to the glass substrate 24 such that the opposite ends of the photosensitive resin layers 28 are spaced equal distances outwardly from the ends of the applied length L.

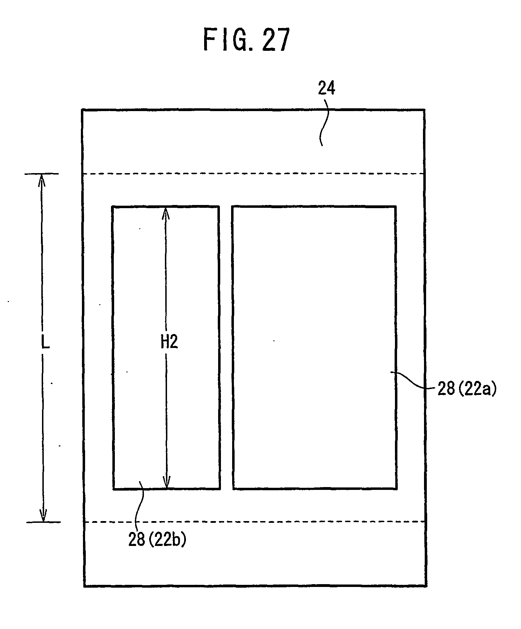

If the length H2 of each of the photosensitive resin layers 28 which is detected by the first and second detecting mechanisms 121a, 121b is smaller than the normal length H, as shown in FIG. 27, then the photosensitive resin layers 28 are applied centrally to the glass substrate 24 such that the opposite ends of the photosensitive resin layers 28 are spaced equal distances inwardly from the ends of the applied length L. In this case, a target displacement of the applied position of the photosensitive resin layers 28 is about one-half the displacement that occurs if the opposite ends of the photosensitive resin layers 28 are not spaced equal distances inwardly from the ends of the applied length L.

According to the second embodiment, furthermore, the partly cut regions 34 are formed in the photosensitive webs 22a, 22b unreeled from the first and second reel-out mechanisms 32a, 32b, and then the protective films 30 are peeled off, leaving the residual sections 30b, after which the photosensitive webs 22a, 22b are laminated onto the glass substrate 24 to transfer the photosensitive resin layers 28, and then the base films 26 and the residual sections 30b are peeled off by the base peeling mechanism 124, thereby manufacturing the photosensitive laminated body 106. The photosensitive laminated body 106 can be manufactured easily automatically.

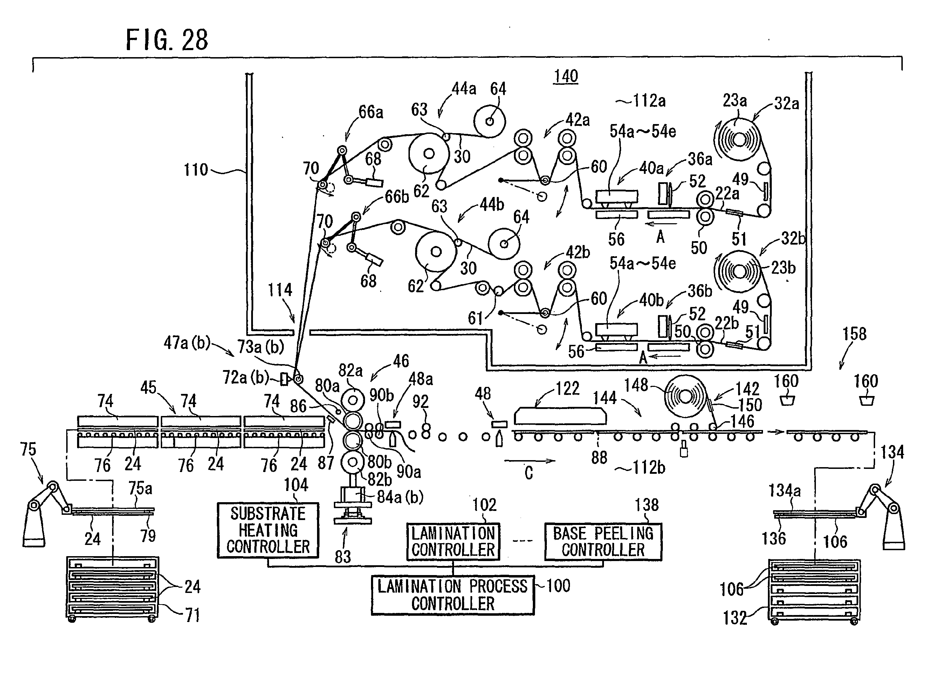

FIG. 28 schematically shows in side elevation a manufacturing apparatus 140 according to a third embodiment of the present invention. Those parts of the manufacturing apparatus 140 according to the third embodiment which are identical to those of the manufacturing apparatus 20 according to the first embodiment are denoted by identical reference characters, and will not be described in detail below.

The manufacturing apparatus 140 includes the inter-substrate web cutting mechanism 48 which is usually not used except for cutting off the photosensitive webs 22a, 22b in case of trouble and separating the photosensitive webs 22a, 22b to discharge defective sections. The manufacturing apparatus 140 has a cooling mechanism 122 and an automatic base peeling mechanism 142 which are disposed downstream of the web cutting mechanism 48a. The automatic base peeling mechanism 142 serves to continuously peel off elongate base films 26 by which glass substrates 24 spaced at given intervals are joined together. The automatic base peeling mechanism 142 has a prepeeler 144, a peeling roller 146 having a relatively small diameter, a takeup roll 148, and an automatic joining unit 150.

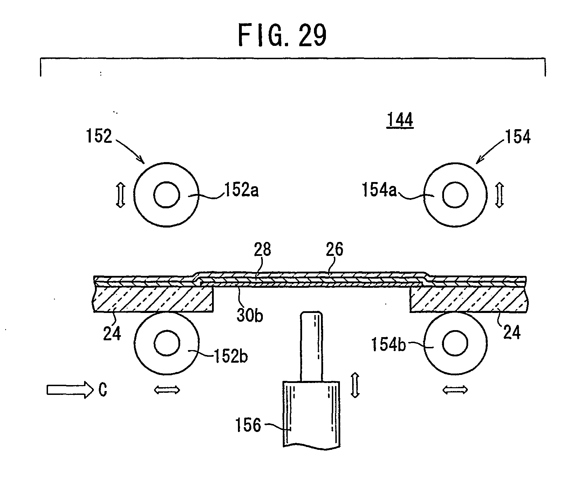

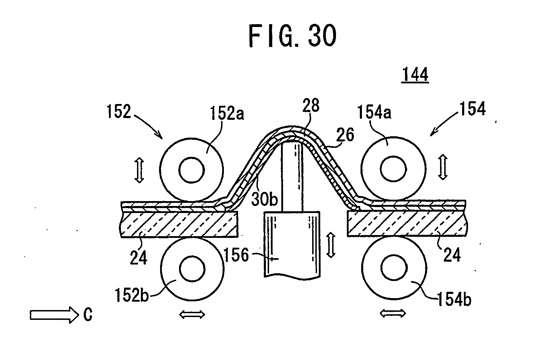

As shown in FIGS. 29 and 30, the prepeeler 144 has a pair of nip roller assemblies 152, 154 and a peeling bar 156. The nip roller assemblies 152, 154 are movable toward and away from each other in the direction in which glass substrates 24 are fed. The nip roller assemblies 152, 154 have vertically movable upper rollers 152a, 154a and lower rollers 152b, 154b. When the upper rollers 152a, 154a are lowered, the upper rollers 152a, 154a and the lower rollers 152b, 154b grip glass substrates 24 therebetween. The peeling bar 156 is vertically movable between adjacent glass substrates 24. The upper rollers 152a, 154a may be replaced with presser bars or presser pins.

The photosensitive webs 22a, 22b are reheated to a temperature in the range from 30°C to 120°C by the peeling roller 146 or at a position immediately before the peeling roller 146. When the photosensitive webs 22a, 22b are thus reheated, color material layers are prevented from being peeled off therefrom when the base films 26 are peeled off, so that a high-quality laminated surface can be produced on the glass substrates 24.

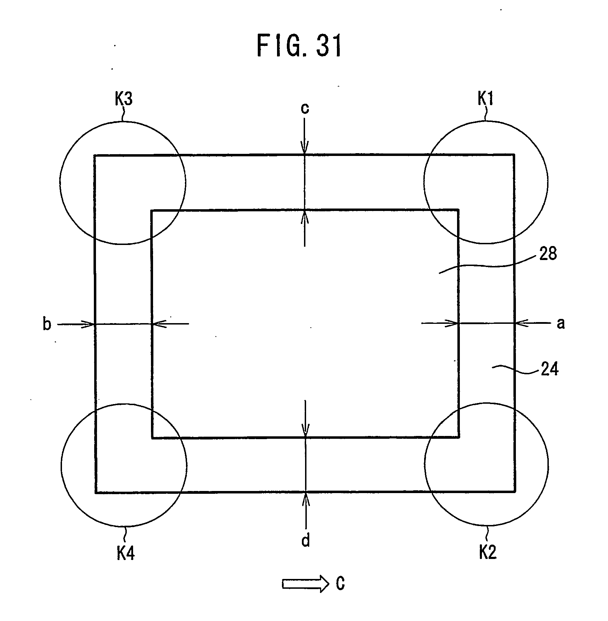

The automatic base peeling mechanism 142 is followed downstream by a measuring unit 158 for measuring the area of a photosensitive resin layer 28 that is actually joined to a glass substrate 24. The measuring unit 158 has a plurality of spaced cameras 160 each comprising a CCD or the like. As shown in FIG. 31, the measuring unit 158 has four cameras 160, for example, for capturing the images of four corners K1 through K4 of a glass substrate 24 to which a photosensitive resin layer 28 is joined. Alternatively, the measuring unit 158 may have at least two cameras for capturing the images of each of longitudinal and transverse sides of a glass substrate 24, rather than the four corners K1 through K4 thereof.

The measuring unit 158 may comprise color sensors or laser sensors for detecting end faces of a glass substrate 24 or may comprise a combination of LED sensors, photodiode sensors, or line sensors for detecting end faces of a glass substrate 24. At least two of these sensors should desirably be employed to capture the image of each of the end faces for detecting the linearity of each of the end faces.

Surface inspection units (not shown) may be employed to detect surface defects of photosensitive laminated bodies 106, such as surface irregularities caused by the photosensitive webs 22a, 22b themselves, laminated film density irregularities caused by the manufacturing facility, wrinkles, striped patterns, dust particles, and other foreign matter. When such a surface defect is detected, the manufacturing apparatus 140 issues an alarm, ejects defective products, and manages subsequent processes based on the detected surface defect.

According to the third embodiment, the joined substrate 24a to which the photosensitive webs 22a, 22b are laminated is cooled by the cooling mechanism 122 and then delivered to the prepeeler 144. In the prepeeler 144, the nip roller assemblies 152, 154 grip the trailing and leading ends of two adjacent glass substrates 24, and the nip roller assembly 152 moves in the direction indicated by the arrow C at the same speed as the glass substrates 24, with the nip roller assembly 154 being decelerated in its travel in the direction indicated by the arrow C.

Consequently, as shown in FIG. 30, the photosensitive webs 22a, 22b between the glass substrates 24 are flexed between the nip roller assemblies 152, 154. Then, the peeling bar 156 is lifted to push the photosensitive webs 22a, 22b upwardly, peeling the projecting films 30 off from the trailing and leading ends of the two adjacent glass substrates 24.

In the automatic base peeling mechanism 142, the takeup roll 148 is rotated to continuously wind the base films 26 from the joined substrate 24a. After the photosensitive webs 22a, 22b are cut off in case of trouble and separated to discharge defective sections, leading ends of the base films 26 on a joined substrate 24a to which the photosensitive webs 22a, 22b start being laminated and the trailing ends of the base films 26 wound on the takeup roll 148 are automatically joined to each other by the automatic joining unit 150.

The glass substrate 24 from which the base films 26 are peeled off is placed in an inspecting station combined with the measuring unit 158. In the inspecting station, the glass substrate 24 is fixed in place, and the four cameras 160 capture the images of the glass substrate 24 and the photosensitive resin layer 28. The captured images are processed to determine applied positions a through d.

In the inspecting station, the glass substrate 24 may be fed along without being stopped, and transverse ends of the glass substrate 24 may be detected by cameras or image scanning, and longitudinal ends thereof may be detected by timing sensors. Then, the glass substrate 24 may be measured based on the detected data produced by the cameras or image scanning and the sensors.

According to the third embodiment, after the photosensitive webs 22a, 22b have been laminated onto glass substrates 24, the photosensitive webs 22a, 22b between two adjacent joined substrates 24a are not cut off. Rather, while the joined substrates 24a are being pressed by the peeling roller 146, the base films 26 are continuously peeled off from the joined substrates 24a and wound around the takeup roll 148 which is in rotation.

According to the third embodiment, the same advantages as those of the second embodiment are achieved, e.g., the photosensitive laminated body 106 can be manufactured automatically and efficiently. Furthermore, the manufacturing apparatus 140 is simple in structure. In the second and third embodiments, the two photosensitive web rolls 23a, 23b are employed. However, the manufacturing apparatus according to the second and third embodiments may employ three or more photosensitive web rolls.

Although certain preferred embodiments of the present invention have been shown and described in detail, it should be understood that various changes and modifications may be made therein without departing from the scope of the appended claims.

## Claims

1. An apparatus for manufacturing a photosensitive laminated body, comprising:
at least two web reel-out mechanisms (32a, 32b) for synchronously reeling out elongate photosensitive webs (22a, 22b) each comprising a support (26), a photosensitive material layer (28) disposed on said support (26), and a protective film (30) disposed on said photosensitive material layer (28), said protective film (30) having a peel-off section (30aa) and a residual section (30b);
at least two processing mechanisms (36a, 36b) for forming processed regions (34) which are transversely severable in said protective films (30) of said elongate photosensitive webs (22a, 22b) which have been reeled out by said web reel-out mechanisms (32a, 32b), at respective boundary positions between said peel-off section (30aa) and said residual section (30b);
at least two peeling mechanisms (44a, 44b) for peeling said peel-off section (30aa) off from each of said elongate photosensitive webs (22a, 22b), leaving said residual section (30b);
a substrate feed mechanism (45) for feeding a substrate (24) which has been heated to a predetermined temperature to a joining position;
a joining mechanism (46) for positioning said residual section (30b) between said substrates (24) and joining at least two exposed areas of said photosensitive material layers (28) from which said peel-off section (30aa) is peeled off, integrally parallel to each other to said substrate (24) in said joining position, for producing a joined substrate (24a);
at least two detecting mechanisms (47a, 47b) disposed closely to said joining position, for directly detecting said boundary positions of said elongate photosensitive webs (22a, 22b) or detecting marks disposed on said elongate photosensitive webs (22a, 22b) in association with said boundary positions; and
a control mechanism (102) for adjusting relative positions of said boundary positions and said substrate (24) in said joining position and relative positions of said boundary positions themselves, based on boundary position information detected by said detecting mechanisms (47a, 47b).

2. An apparatus according to claim 1, wherein said detecting mechanisms (47a, 47b) are disposed upstream of and closely to said joining position.

3. An apparatus according to claim 1, further comprising reservoir mechanisms (42a, 42b) disposed between said processing mechanisms (36a, 36b) and said peeling mechanisms (44a, 44b), for changing speeds or states at which said elongate photosensitive webs (22a, 22b) are fed.

4. An apparatus according to any one of claims 1 through 3, further comprising at least two tension control mechanisms (66a, 66b) disposed between said peeling mechanisms (44a, 44b) and said joining mechanism (46), for applying tension to said elongate photosensitive webs (22a, 22b).

5. An apparatus according to any one of claims 1 through 3, further comprising a cutting mechanism (48) disposed downstream of said joining mechanism (46), for cutting off said elongate photosensitive webs (22a, 22b) together between said substrates (24).

6. An apparatus according to any one of claims 1 through 3, further comprising at least two support peeling mechanisms (124) disposed downstream of said joining mechanism (46), for peeling said supports (26) off from each of said joined substrates (24a).

7. An apparatus according to claim 1, wherein said joining mechanism (46) comprises:
a pair of rubber rollers (80a, 80b) which is heated to a predetermined temperature; and
a roller clamp unit (83) for moving one of said rubber rollers (80b) back and forth;
said roller clamp unit (83) comprising:
a cylinder (84a) for applying a clamping pressure to said one of said rubber rollers (80b); and
a cam (97a) movable by an actuator (93) for moving said cylinder (84a) back and forth.

8. An apparatus according to claim 1, further comprising a preheating unit (87) disposed upstream of and closely to said joining mechanism (46), for preheating said elongate photosensitive webs (22a, 22b) to a predetermined temperature.

9. A method of manufacturing a photosensitive laminated body, comprising the steps of:
synchronously reeling out elongate photosensitive webs (22a, 22b) each comprising a support (26), a photosensitive material layer (28) disposed on said support (26), and a protective film (30) disposed on said photosensitive material layer (28), said protective film (30) having a peel-off section (30aa) and a residual section (30b);
forming processed regions (34) which are transversely severable in said protective films (30) of said elongate photosensitive webs (22a, 22b) which have been reeled out, at respective boundary positions between said peel-off section (30aa) and said residual section (30b);
peeling said peel-off section (30aa) off from each of said elongate photosensitive webs (22a, 22b), leaving said residual section (30b);
obtaining boundary position information by directly detecting said boundary positions of said elongate photosensitive webs (22a, 22b) or detecting marks disposed on said elongate photosensitive webs (22a, 22b) in association with said boundary positions;
feeding a substrate (24) which has been heated to a predetermined temperature to a joining position;
adjusting relative positions of said boundary positions and said substrate (24) in said joining position and relative positions of said boundary positions themselves, based on said obtained boundary position information; and
positioning said residual section (30b) between said substrates (24) and joining at least two exposed areas of said photosensitive material layers (28) from which said peel-off section (30aa) is peeled off, integrally parallel to each other to said substrate (24) in said joining position for producing a joined substrate (24a).

10. A method according to claim 9, wherein said boundary position information is obtained upstream of and closely to said joining position.

11. A method according to claim 9, further comprising the steps of:
intermittently feeding said elongate photosensitive webs (22a, 22b) through said processing mechanisms (36a, 36b), respectively; and
thereafter, continuously feeding said elongate photosensitive webs (22a, 22b) through reservoir mechanisms (42a, 42b), respectively, in respective peeling mechanisms (44a, 44b) and subsequently thereto.

12. A method according to any one of claims 9 through 11, further comprising the step of applying tension to said elongate photosensitive webs (22a, 22b) between said step of peeling said peel-off section (30aa) and said step of joining at least two exposed areas of said photosensitive material layers (28).

13. A method according to any one of claims 9 through 11, further comprising the steps of:
cutting off said elongate photosensitive webs (22a, 22b) between said substrates (24) after said step of joining at least two exposed areas of said photosensitive material layers (28); and
thereafter, peeling said supports (26) from said joined substrate (24a) to produce a photosensitive laminated assembly (106).

14. A method according to any one of claims 9 through 11, further comprising the step of continuously or intermittently peeling said supports (26) from said joined substrate (24a) to produce a photosensitive laminated assembly (106) after said step of joining at least two exposed areas of said photosensitive material layers (28).

15. A method according to any one of claims 9 through 11, further comprising the step of preheating said elongate photosensitive webs (22a, 22b) to a predetermined temperature before said step of joining at least two exposed areas of said photosensitive material layers (28).

## Patentansprüche

1. Vorrichtung zum Herstellen eines fotoempfindlichen laminierten Körpers, der umfasst:
wenigstens zwei Bahn-Abwickelmechanismen (32a, 32b) zum synchronen Abwickeln länglicher fotoempfindlicher Bahnen (22a, 22b), die jeweils einen Träger (26), eine Schicht (28) aus fotoempfindlichem Material, die auf dem Träger (26) angeordnet ist, und einen schützenden Film (30) umfassen, der auf der Schicht (28) aus fotoempfindlichem Material angeordnet ist, wobei der schützende Film (30) einen Abziehabschnitt (30aa) und einen zurückbleibenden Abschnitt (30b) aufweist;
wenigstens zwei Bearbeitungsmechanismen (36a, 36b) zum Ausbilden bearbeiteter Bereiche (34), die quer durchtrennt werden können, in den schützenden Filmen (30) der länglichen fotoempfindlichen Bahnen (22a, 22b), die durch die Bahn-Abwickelmechanismen (32a, 32b) abgewickelt werden können, an jeweiligen Grenzpositionen zwischen dem Abziehabschnitt (30aa) und dem zurückbleibenden Abschnitt (30b);
wenigstens zwei Abziehmechanismen (44a, 44b), mit denen der Abziehabschnitt (30aa) von den länglichen fotoempfindlichen Bahnen (22a, 22b) so abgewickelt wird, dass der zurückbleibende Abschnitt (30b) verbleibt;
einen Substrat-Zuführmechanismus (45) zum Zuführen eines Substrats (24), das auf eine vorgegebene Temperatur erhitzt worden ist, zu einer Zusammenfügeposition;
einen Zusammenfügemechanismus (46), mit dem der zurückbleibende Abschnitt (30b) zwischen den Substraten (24) positioniert wird und wenigstens zwei freiliegende Zonen der Schichten (28) aus dem fotoempfindlichen Material, von denen der Abziehabschnitt (30aa) abgezogen ist, integral parallel zueinander mit dem Substrat (24) in der Zusammenfügeposition zusammengefügt werden, um ein zusammengefügtes Substrat (24a) zu erzeugen;
wenigstens zwei nahe an der Zusammenfügeposition angeordnete Erfassungsmechanismen (47a, 47b), mit denen die Grenzpositionen der länglichen fotoempfindlichen Bahnen (22a, 22b) direkt erfasst werden oder Markierungen erfasst werden, die auf den länglichen fotoempfindlichen Bahnen (22a, 22b) in Verbindung mit den Grenzpositionen angeordnet sind;
einen Steuermechanismus (102) zum Regulieren relativer Positionen der Grenzpositionen und des Substrats (24) an der Zusammenfügeposition sowie relativer Positionen der Grenzpositionen selbst auf Basis durch die Erfassungsmechanismen (47a, 47b) erfasster Grenzpositions-Informationen.

2. Vorrichtung nach Anspruch 1, wobei die Erfassungsmechanismen (47a, 47b) stromauf von und nahe an der Zusammenfügeposition angeordnet sind.

3. Vorrichtung nach Anspruch 1, die des Weiteren zwischen den Bearbeitungsmechanismen (36a, 36b) und den Abziehmechanismen (44a, 44b) angeordnete Speichermechanismen (42a, 42b) umfasst, mit denen Geschwindigkeiten oder Zustände geändert werden, mit denen die länglichen fotoempfindlichen Bahnen (22a, 22b) zugeführt werden.

4. Vorrichtung nach einem der Ansprüche 1 bis 3, die des Weiteren wenigstens zwei zwischen den Abziehmechanismen (44a, 44b) und dem Zusammenfügemechanismus (46) angeordnete Spannungssteuermechanismen (66a, 66b) zum Ausüben von Spannung auf die länglichen fotoempfindlichen Bahnen (22a, 22b) umfasst.

5. Vorrichtung nach einem der Ansprüche 1 bis 3, die des Weiteren einen hinter dem Zusammenfügemechanismus (46) angeordneten Schneidmechanismus (48) umfasst, mit dem die länglichen fotoempfindlichen Bahnen (22a, 22b) zusammen zwischen den Substraten (24) abgeschnitten werden.

6. Vorrichtung nach einem der Ansprüche 1 bis 3, die des Weiteren wenigstens zwei hinter dem Zusammenfügemechanismus (46) angeordnete Träger-Abziehmechanismen (124) zum Abziehen der Träger (26) von jedem der zusammengefügten Substrate (24a) umfasst.

7. Vorrichtung nach Anspruch 1, wobei der Verbindungsmechanismus (46) umfasst:
ein Paar Gummiwalzen (21), die auf eine vorgegebene Temperatur erhitzt werden; und
eine Walzen-Klemmeinheit (83) zum Hin- und Herbewegen einer der Gummiwalzen (80b);
wobei die Walzen-Klemmeinheit (83) umfasst:
einen Zylinder (84a) zum Ausüben eines Klemmdrucks auf eine der Gummiwalzen (80b); und
einen Nocken (97a), der durch ein Betätigungselement (93) bewegt werden kann, um den Zylinder hin- und herzubewegen.

8. Vorrichtung nach Anspruch 1, die des Weiteren eine Vorheizeinheit (87) umfasst, die stromab von dem Zusammenfügemechanismus (46) und nahe daran angeordnet ist, und mit der die länglichen fotoempfindlichen Bahnen (22a, 22b) auf eine vorgegebene Temperatur vorerhitzt werden.

9. Verfahren zum Herstellen eines fotoempfindlichen laminierten Körpers, das die folgenden Schritte umfasst:
synchrones Abwickeln länglicher fotoempfindlicher Bahnen (22a, 22b), die jeweils einen Träger (26), eine Schicht (28) aus fotoempfindlichem Material, die auf dem Träger (26) angeordnet ist, und einen schützenden Film (30) umfassen, der auf der Schicht (28) aus fotoempfindlichem Material angeordnet ist, wobei der schützende Film (30) einen Abziehabschnitt (30aa) und einen zurückbleibenden Abschnitt (30b) aufweist;
Ausbilden bearbeiteter Bereiche (34), die quer durchgetrennt werden können, in den schützenden Filmen (30) der länglichen fotoempfindlichen Bahnen (22a, 22b), die abgewickelt worden sind, an jeweiligen Grenzpositionen zwischen dem Abziehabschnitt (30aa) und dem zurückbleibenden Abschnitt (30b);
Abziehen des Abziehabschnitts (30aa) jeder der länglichen fotoempfindlichen Bahnen (22a, 22b), so dass der zurückbleibende Abschnitt (30b) verbleibt;
Ermitteln von Grenzpositionsinformationen durch direktes Erfassen der Grenzpositionen der länglichen fotoempfindlichen Bahnen (22a, 22b) oder Erfassen von Zeichen, die auf den länglichen fotoempfindlichen Bahnen (22a, 22b) in Verbindung mit den Grenzpositionen angeordnet sind;
Zuführen eines Substrats (24), das auf eine vorgegebene Temperatur erhitzt worden ist, zu einer Zusammenfügeposition;
Regulieren relativer Positionen der Grenzpositionen und des Substrats (24) an der Zusammenfügeposition und relativer Positionen der Grenzpositionen selbst auf Basis der bezogenen Grenzpositions-Informationen; und
Positionieren des zurückbleibenden Abschnitts (30b) zwischen den Substraten (24) und Zusammenfügen wenigstens zweier freiliegender Zonen der Schichten aus fotoempfindlichem Material (28), von denen der Abziehabschnitt (30aa) abgezogen ist, integral parallel zueinander mit dem Substrat (24) an der Zusammenfügeposition, um ein zusammengefügtes Substrat (24a) zu erzeugen.

10. Verfahren nach Anspruch 9, wobei die Grenzpositionsinformationen stromauf vor der Zusammenfügeposition und nahe daran ermittelt werden.

11. Verfahren nach Anspruch 9, das des Weiteren die folgenden Schritte umfasst:
intermittierendes Transportieren der länglichen fotoempfindlichen Bahnen (22a, 22b) jeweils durch die Bearbeitungsmechanismen (36a, 36b); und
anschließend kontinuierliches Transportieren der länglichen fotoempfindlichen Bahnen (22a, 22b) jeweils durch Vorratsbehälter-Mechanismen (42a, 42b) in jeweiligen Abziehmechanismen (44a, 44b), die darauf folgen.

12. Verfahren nach einem der Ansprüche 9 bis 11, das des Weiteren den Schritt des Ausübens von Spannung auf die länglichen fotoempfindlichen Bahnen (22a, 22b) zwischen dem Schritt des Abziehens des Abziehabschnitts (30aa) und dem Schritt des Zusammenfügens wenigstens zweier freiliegender Zonen der fotoempfindlichen Materialschichten (28) umfasst.

13. Verfahren nach einem der Ansprüche 9 bis 11, das des Weiteren die folgenden Schritte umfasst:
Abschneiden der länglichen fotoempfindlichen Bahnen (22a, 22b) zwischen den Substraten (24) nach dem Schritt des Zusammenfügens wenigstens zweier freiliegender Zonen der Schichten (28) aus fotoempfindlichen Material; und anschließend Abziehen der Träger (26) von dem zusammengefügten Substrat (24a), um eine fotoempfindliche laminierte Anordnung (106) zu erzeugen.

14. Verfahren nach einem der Ansprüche 9 bis 11, das des Weiteren den Schritt des kontinuierlichen oder intermittierenden Abziehens der Träger (26) von dem zusammengefügten Substrat (24) zum Erzeugen einer fotoempfindlichen laminierten Anordnung (106) nach dem Schritt des Zusammenfügens wenigstens zweier freiliegender Zonen der Schichten (28) aus fotoempfindlichem Material umfasst.

15. Verfahren nach einem der Ansprüche 9 bis 11, das des Weiteren den Schritt des Vorheizens der länglichen fotoempfindlichen Bahnen (22a, 22b) auf eine vorgegebene Temperatur vor dem Schritt des Zusammenfügens wenigstens zweier freiliegender Zonen der Schichten (28) aus fotoempfindlichem Material umfasst.

## Revendications

1. Appareil pour la fabrication d'un corps stratifié photosensible, comportant :
au moins deux mécanismes de déroulement de bande (32a, 32b) destinés à dérouler de manière synchrone des bandes photosensibles allongées (22a, 22b) comportant chacune un support (26), une couche de matière photosensible (28) disposée sur ledit support (26), et un film de protection (30) disposé sur ladite couche de matière photosensible (28), ledit film de protection (30) ayant une section à décoller (30aa) et une section résiduelle (30b) ;
au moins deux mécanismes de traitement (36a, 36b) destinés à former des zones traitées (34) qui peuvent être séparées transversalement dans lesdits films de protection (30) desdites bandes photosensibles allongées (22a, 22b) qui ont été déroulées par lesdits mécanismes de déroulement de bande (32a, 32b), au niveau de zones de limites respectives entre ladite section à décoller (30aa) et ladite section résiduelle (30b) ;
au moins deux mécanismes de décollement (44a, 44b) destinés à décoller ladite section à décoller (30aa) de chacune desdites bandes photosensibles allongées (22a, 22b), en laissant ladite section résiduelle (30b) ;
un mécanisme d'avance de substrat (45) destiné à avancer jusqu'à une position de raccordement un substrat (24) qui a été chauffé à une température prédéterminée ;
un mécanisme de raccordement (46) destiné à positionner ladite section résiduelle (30b) entre lesdits substrats (24) et à relier au moins deux zones exposées desdites couches de matière photosensible (28) desquelles ladite section à décoller (30aa) est décollée, intégralement parallèles l'une à l'autre audit substrat (24) dans ladite position de raccordement, afin de produire un substrat raccordé (24a) ;
au moins deux mécanismes de détection (47a, 47b) disposés à proximité de ladite position de raccordement, destinés à détecter directement lesdites positions de limite desdites bandes photosensibles allongées (22a, 22b) ou à détecter des repères disposés sur lesdites bandes photosensibles allongées (22a, 22b) en association avec lesdites positions de limite ; et
un mécanisme de commande (102) destiné à ajuster des positions relatives desdites positions de limite et dudit substrat (24) dans ladite position de raccordement et des positions relatives desdites positions de limite elles-mêmes, sur la base de l'information de position de limite détectée par lesdits mécanismes de détection (47a, 47b).

2. Appareil selon la revendication 1, dans lequel lesdits mécanismes de détection (47a, 47b) sont disposés en amont et à proximité de ladite position de raccordement.

3. Appareil selon la revendication 1, comportant en outre des mécanismes de réservoir (42a, 42b) disposés entre lesdits mécanismes de traitement (36a, 36b) et lesdits mécanismes de décollement (44a, 44b), afin de changer des vitesses ou des états dans lesquels lesdites bandes photosensibles allongées (22a, 22b) sont avancées.

4. Appareil selon l'une quelconque des revendications 1 à 3, comportant en outre au moins deux mécanismes de commande de tension (66a, 66b) disposés entre lesdits mécanismes de décollement (44a, 44b) et ledit mécanisme de raccordement (46), afin d'appliquer une tension sur lesdites bandes photosensibles allongées (22a, 22b).

5. Appareil selon l'une quelconque des revendications 1 à 3, comportant en outre un mécanisme de coupe (48) disposé en aval dudit mécanisme de raccordement (46), afin de découper lesdites bandes photosensibles allongées (22a, 22b) ensemble entre lesdits substrats (24).

6. Appareil selon l'une quelconque des revendications 1 à 3, comportant en outre au moins deux mécanismes de décollement de support (124) disposés en aval dudit mécanisme de raccordement (46), afin de décoller ledit support (26) de chacun desdits substrats raccordés (24a).

7. Appareil selon la revendication 1, dans lequel ledit mécanisme de raccordement (46) comporte :
une paire de rouleaux en caoutchouc (80a, 80b) qui est chauffée à une température prédéterminée ; et
une unité de serrage de rouleau (83) destinée à déplacer un desdits rouleaux en caoutchouc (80b) en arrière et en avant ;
ladite unité de serrage de rouleau (83) comportant :
un cylindre (84a) destiné à appliquer une pression de serrage sur ledit rouleau desdits rouleaux en caoutchouc (80b) ; et
une came (97a) mobile grâce à un dispositif d'actionnement (93) de façon à déplacer ledit cylindre (84a) en arrière et en avant.

8. Appareil selon la revendication 1, comportant en outre une unité de préchauffage (87) disposée en amont et à proximité dudit mécanisme de raccordement (46), afin de préchauffer lesdites bandes photosensibles allongées (22a, 22b) à une température prédéterminée.

9. Procédé de fabrication d'un corps stratifié photosensible, comportant les étapes consistant à :
dérouler de manière synchrone des bandes photosensibles allongées (22a, 22b) comportant chacune un support (26), une couche de matière photosensible (28) disposée sur ledit support (26), et un film de protection (30) disposé sur ladite couche de matière photosensible (28), ledit film de protection (30) ayant une section à décoller (30aa) et une section résiduelle (30b) ;
former des zones traitées (34) qui peuvent être séparées transversalement dans lesdits films de protection (30) desdites bandes photosensibles allongées (22a, 22b) qui ont été déroulées, au niveau de zones de limites respectives entre ladite section à décoller (30aa) et ladite section résiduelle (30b) ;
décoller ladite section à décoller (30aa) de chacune desdites bandes photosensibles allongées (22a, 22b), en laissant ladite section résiduelle (30b) ;
obtenir une information de position de limite en détectant directement lesdites positions de limite desdites bandes photosensibles allongées (22a, 22b) ou en détectant des repères disposés sur lesdites bandes photosensibles allongées (22a, 22b) en association avec lesdites positions de limite ;
avancer jusqu'à une position de raccordement un substrat (24) qui a été chauffé à une température prédéterminée ;
ajuster des positions relatives desdites positions de limite et dudit substrat (24) dans ladite position de raccordement et des positions relatives desdites positions de limite elles-mêmes, sur la base de ladite information de position de limite obtenue ; et
positionner ladite section résiduelle (30b) entre lesdits substrats (24) et relier au moins deux zones exposées desdites couches de matière photosensible (28) desquelles ladite section à décoller (30aa) est décollée, intégralement parallèles l'une à l'autre audit substrat (24) dans ladite position de raccordement afin de produire un substrat raccordé (24a).

10. Procédé selon la revendication 9, selon lequel ladite information de position de limite est obtenue en amont et à proximité de ladite position de raccordement.

11. Procédé selon la revendication 9, comportant en outre les étapes consistant à :
avancer par intermittence lesdites bandes photosensibles allongées (22a, 22b) à travers lesdits mécanismes de traitement (36a, 36b), respectivement ; et
ensuite, avancer de manière continue lesdites bandes photosensibles allongées (22a, 22b) à travers des mécanismes de réservoir (42a, 42b), respectivement, dans des mécanismes de décollement respectifs (44a, 44b) et ensuite dessus.

12. Procédé selon l'une quelconque des revendications 9 à 11, comportant en outre l'étape d'application d'une tension sur lesdites bandes photosensibles allongées (22a, 22b) entre ladite étape de décollement de ladite section à décoller (30aa) et ladite étape de raccordement d'au moins deux zones exposées desdites couches de matière photosensible (28).

13. Procédé selon l'une quelconque des revendications 9 à 11, comportant en outre les étapes consistant à :
découper lesdites bandes photosensibles allongées (22a, 22b) entre lesdits substrats (24) après ladite étape de raccordement d'au moins deux zones exposées desdites couches de matière photosensible (28) ; et
ensuite, décoller lesdits supports (26) dudit substrat raccordé (24a) afin de produire un ensemble stratifié photosensible (106).

14. Procédé selon l'une quelconque des revendications 9 à 11, comportant en outre l'étape de décollement de manière continue ou par intermittence desdits supports (26) dudit substrat raccordé (24a) afin de produire un ensemble stratifié photosensible (106) après ladite étape de raccordement d'au moins deux zones exposées desdites couches de matière photosensible (28).

15. Procédé selon l'une quelconque des revendications 9 à 11, comportant en outre l'étape de préchauffage desdites bandes photosensibles allongées (22a, 22b) à une température prédéterminée avant ladite étape de raccordement d'au moins deux zones exposées desdites couches de matière photosensible (28).
